# EUROPEAN PATENT APPLICATION

(11) **EP 4 761 508 A1**
(43) Date of publication of application: **17.06.2026**
(21) Application number: 25217877.7
(22) Date of filing: 24.11.2025
(51) Int. Cl.: H10D 62/10, H10D 30/01, H10D 30/00, H10D 84/01, H10D 84/83, H10D 84/85

(54) **GATE METALLIZATION FOR INTEGRATED CIRCUIT STRUCTURES**

(30) Priority: 12.12.2024 US 202418978319
(71) Applicant: Intel Corporation, Santa Clara, CA 95054 (US)
(72) Inventor: XU, Guowei, Portland, 97229 (US); CHU, Tao, Portland, 97229 (US); ZHANG, Kan, Hillsboro, 97123 (US); CHAO, Robin, Portland, 97209 (US); HUNG, Ting-Hsiang, Santa Clara, 95051 (US); ZHANG, Feng, Portland, 97229 (US); LIN, Chia-Ching, Portland, 97229 (US); YEUNG, Chun Wing, Portland, 97229 (US); LIN, Chung-Hsun, Portland, 97229 (US); GOLONZKA, Oleg, Beaverton, 97007 (US); GHANI, Tahir, Portland, 97229 (US); ZHANG, Yang, Rio Rancho, 87124 (US); LEE, Ming-Hsun, Vancouver, 98683 (US)
(74) Representative: 2SPL Patentanwälte PartG mbB

(57) **Abstract**

Disclosed herein are gate metallization techniques for integrated circuit (IC) structures, and related methods and devices. In one aspect, a resulting IC structure may include a nanoribbon comprising a semiconductor material, and a P-type transistor comprising a gate electrode at least partially wrapping around a portion of the nanoribbon. In such an IC structure, the gate electrode includes a stack of conductive materials, the stack comprising a first conductive material, a second conductive material, and a third conductive material, wherein the second conductive material is between the first conductive material and the third conductive material and includes titanium.

## Description

### Background

For the past several decades, the scaling of features in integrated circuit (IC) structures has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize every portion of an IC structure becomes increasingly significant.

The term "gate metallization" in IC fabrication generally refers to the process of depositing one or more conductive materials to form a gate electrode of a transistor, typically in a Metal-Oxide-Semiconductor Field-Effect Transistor (MOSFET). This electrode serves as a control terminal to regulate the flow of current through the transistor.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example IC structure implementing a nanoribbon transistor that may be fabricated using gate metallization described herein, in accordance with some embodiments.
FIG. 2 is a flow diagram of a gate metallization method for fabricating an IC structure, in accordance with some embodiments.
FIGS. 3A-3L are cross-sectional side views illustrating example IC structures after various processes of the method of FIG. 2, in accordance with some embodiments.
FIG. 4 illustrates top views of a wafer and dies that may include one or more IC structures with gates formed using the gate metallization method described herein, in accordance with some embodiments.
FIG. 5 is a side, cross-sectional view of an IC device that may include one or more IC structures with gates formed using the gate metallization method described herein, in accordance with some embodiments.
FIG. 6 is a side, cross-sectional view of an IC package that may include one or more IC structures with gates formed using the gate metallization method described herein, in accordance with some embodiments.
FIG. 7 illustrates a cross-sectional side view of an IC device assembly that may include one or more IC structures with gates formed using the gate metallization method described herein, in accordance with some embodiments.
FIG. 8 is a block diagram of an example computing device that may include one or more IC structures with gates formed using the gate metallization method described herein, in accordance with some embodiments.
FIG. 9 is a block diagram of an example processing device that may include one or more IC structures with gates formed using the gate metallization method described herein, in accordance with some embodiments.

### Detailed Description

Disclosed herein are gate metallization techniques for IC structures, and related methods and devices. The systems, methods, and devices of this disclosure each have several innovative aspects, no single one of which is solely responsible for all the desirable attributes disclosed herein. Details of one or more implementations of the subject matter described in this specification are set forth in the description below and the accompanying drawings.

For purposes of illustrating gate metallization techniques for IC structures, proposed herein, it might be useful to first understand phenomena that may come into play in IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

A field-effect transistor (FET), e.g., a MOSFET, is a three-terminal device that includes source, drain, and gate terminals and uses electric field to control current flowing through the device. A FET typically includes a semiconductor material forming a channel portion of a transistor, a source region and a drain region provided on either side of the channel portion, and a gate stack that includes at least a gate electrode material and, optionally, may also include a gate insulator, where the gate stack is provided over at least a portion of the channel portion between the source region and the drain region.

Recently, FETs with non-planar architectures, such as nanoribbon transistors (also sometimes referred to as "gate all-around (GAA) transistors"), have been extensively explored as alternatives to transistors with planar architectures. In a nanoribbon transistor, a gate stack may be provided around a portion of an elongated semiconductor structure called "nanoribbon", forming a gate on all sides of the nanoribbon. The "channel" or the "channel portion" of a nanoribbon transistor is the portion of the nanoribbon around which the gate stack wraps. Such transistors are sometimes referred to as "GAA transistors" because, in use, such transistors may form conducting channels on all "sides" of the channel portion of the nanoribbon. A source region and a drain region are provided in the nanoribbon on each side of the gate stack, forming, respectively, a source and a drain of a nanoribbon transistor. In some settings, the terms "nanoribbon" or "nanosheet" have been used to describe an elongated semiconductor structure that has a substantially rectangular transverse cross-section (i.e., a cross-section in a plane perpendicular to the longitudinal axis of the structure), while the term "nanowire" has been used to describe a similar structure but with a substantially circular or square transverse cross-sections. In the present disclosure, the term "nanoribbon" is used to refer to all such nanowires, nanoribbons, and nanosheets, as well as elongated semiconductor structures with a longitudinal axis parallel to the bases and with having transverse cross-sections of any geometry (e.g., transverse cross-sections in the shape of an oval or a polygon with rounded corners). A transistor may then be described as a "nanoribbon transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain regions of a transistor provided on either side of the channel material. As is common in the field of FETs, designations of source and drain are often interchangeable and, therefore, source and drain regions may be referred to as a first source/drain (S/D) region and a second S/D region, where one of the first and second S/D regions is a source region, and the other one is a drain region.

Typically, nanoribbon transistors include stacks of nanoribbons, where each stack includes two or more nanoribbons stacked above one another, with a single gate stack that includes a gate electrode material (which may include a work function material) provided for an entire stack or multiple stacks. Optionally, the gate stack may also include a gate dielectric material around each nanoribbon. Such nanoribbon transistors may be fabricated by, first, providing a stack of alternating layers of first and second semiconductor materials over a base (e.g., a substrate, a die, a wafer, or a chip). The first semiconductor material is a material that will later form nanoribbons, while the second semiconductor material is a material that is etch-selective with respect to the first semiconductor material so that it may later be removed to separate different nanoribbons of a stack from one another. For example, the first semiconductor material may be silicon, while the second semiconductor material may be silicon germanium. In such a fabrication process, the first semiconductor material may provide the bottom layer of the stack as well two or more layers above the bottom layer, alternating with layers of the second semiconductor material, or vice versa. A stack of first and second semiconductor materials alternating with one another is sometimes referred to as a "superlattice". The fabrication process further includes patterning the superlattice, as well as, possibly, an upper portion of the base into a fin to define the width of future nanoribbons. Sidewalls of a bottom portion of the fin are enclosed by an insulator material commonly referred to as a "shallow trench insulator" (STI) and such a bottom portion of the fin enclosed by the STI is commonly referred to as a "subfin," similar to a subfin portion of fin-based transistors. The subfin may include the bottom layer of the first semiconductor material of the superlattice and an upper portion of the base over which the superlattice was provided. The fabrication process further includes removing the second semiconductor material from the fin to release nanoribbons formed by the fin portions of the first semiconductor material above the subfin. After the nanoribbons are released, a gate stack is provided around portions of the nanoribbons formed of the higher levels of the first semiconductor material, while the first semiconductor material in the subfin portion of the fin may remain but does not serve as a part of the nanoribbon-based transistors.

Performance of nanoribbon transistors may depend on a number of factors. Threshold voltage, commonly abbreviated as Vth, refers to the minimum gate-to-source voltage that is needed to create a conducting path between source and drain terminals of a transistor. "Threshold voltage tuning" refers to adapting the threshold voltage of a transistor to a desired value. Some approaches to threshold voltage tuning include using various types of work function materials as portions of gate electrodes of transistors. Some work function materials are suitable for use in N-type metal-oxide-semiconductor (NMOS) transistors and are, therefore, referred to as "N-type work function" (NWF) materials. Other work function materials are suitable for use in P-type metal-oxide-semiconductor (PMOS) transistors and are, therefore, referred to as "P-type work function" (PWF) materials. Work function of a material can be defined as the minimum thermodynamic work (i.e., energy) required to extract one electron from the material. Thus, work function is measured in electron volts (eV) or Joules (J). Work function is one of the fundamental electronic properties of metals, depending on both the bulk composition and surface condition. In context of transistors, NWF materials are generally metals that have a work function that is smaller than the conduction band of the channel material (i.e., the semiconductor material of the channel region of a transistor) or metals that have a work function that is close to (e.g., within +/- 20% of or within +/- 10% of) the conduction band of the channel material, while PWF materials are generally metals that have a work function that is larger than the valence band of the channel material of a transistor or metals that have a work function that is close to (e.g., within +/- 20% of or within +/- 10% of) the valence band of the channel material. Examples of NWF materials are metals and alloys based on titanium and aluminum, such as metals and alloys that include titanium, aluminum, and carbon (e.g., TiAlC), metals and alloys based on metal carbides (e.g., TiC), metals and alloys that include cobalt, etc. Examples of PWF materials are metals and alloys based on metal nitrides (e.g., TiN, MoN, or WN), and tungsten.

Fabricating nanoribbon transistors is not trivial. In particular, as is common in the field of complementary metal-oxide-semiconductor (CMOS) manufacturing, both NMOS and PMOS transistors need to be implemented on the same base (e.g., a substrate or a die). However, gate stacks of NMOS and PMOS transistors require different materials for optimum performance of these transistors and, therefore, care must be taken when NMOS and PMOS transistors are fabricated substantially simultaneously. Conventional approaches to providing gate stacks of NMOS and PMOS transistors include filling a gate region of a PMOS transistor with a gate fill material such as tungsten until tungsten pinches off and blocks deposition of other materials into the gate region of the PMOS transistor in subsequent fabrication steps. To that end, a selective deposition process is typically used to fill the gate region of a PMOS transistor with a gate fill material such as tungsten. Filling the gate region of a PMOS transistor with tungsten to the point of pinch-off ensures that, when a gate stack of an NMOS transistor is formed in a subsequent fabrication step, which includes deposition of an NWF material into a gate region of the NMOS transistor, no NWF material will be able to get into the gate region of a PMOS transistor due to tungsten pinch-off in there. Embodiments of the present disclosure are based on recognition that, while ensuring that no NWF material is present in the gate region of a PMOS transistor may be advantageous in terms of reducing undesirable threshold voltage shifts and performance degradation, presence of a relatively large uninterrupted volume of selectively-deposited tungsten in the gate region of a PMOS transistor may cause bias temperature instability (BTI) in the PMOS transistor. BTI is a serious reliability issue in transistors, particularly MOSFETs, where prolonged operation under bias and elevated temperature causes a gradual shift in the transistor's threshold voltage. This phenomenon degrades device performance over time, impacting circuit stability and lifespan.

A gate metallization method for nanoribbon transistors and associated IC structures and devices that may improve on one or more challenges described above are disclosed. The gate metallization method disclosed herein is based on depositing a sacrificial material in a gate region of a PMOS transistor to the pinch-off point, where, as used herein, "depositing a material to the pinch-off point" refers depositing a material layer in such a way that it substantially seals or closes a narrow gap, trench, or void. After an NWF material has been deposited into a gate region of an NMOS transistor, the sacrificial material is removed and the space where the sacrificial material used to be is lined with a PWF material and filled with a gate fill material such as tungsten. Using a sacrificial material in this manner results in PMOS gate stacks with thinner layers of selectively-deposited tungsten, compared to conventional approaches described above, which may enable to keep the advantages of preventing the NWF material getting into PMOS gate stacks while reducing or eliminating BTI in PMOS transistors. As a result of using the fabrication method described herein, final IC structures have certain unique features that differentiate them from conventional IC structures implementing nanoribbon stacks. For example, in one aspect, an IC structure fabricated using the method described herein may include a nanoribbon comprising a semiconductor material, and a P-type transistor comprising a gate electrode at least partially wrapping around a portion of the nanoribbon. In such an IC structure, the gate electrode includes a stack of conductive materials, the stack comprising a first conductive material, a second conductive material, and a third conductive material, wherein the second conductive material is between the first conductive material and the third conductive material and includes titanium.

IC structures with gates formed using the gate metallization method described herein (e.g., nanoribbon transistors with gate stacks as described herein), may be included in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency (RF) IC (RFIC), which may, e.g., be included in any component associated with an IC of an RF receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations.

In the following detailed description, various aspects of the illustrative implementations may be described using terms commonly employed by those skilled in the art to convey the substance of their work to others skilled in the art. For example, in context of S/D regions of a transistor, the term "region" may be used interchangeably with the terms "contact" and "terminal" of a transistor. In another example, as used herein, the term "connected" means a direct electrical or magnetic connection between the things that are connected, without any intermediary devices, while the term "coupled" means either a direct electrical or magnetic connection between the things that are connected, or an indirect connection through one or more passive or active intermediary devices. The term "circuit" means one or more passive and/or active components that are arranged to cooperate with one another to provide a desired function. If used, the terms "oxide," "carbide," "nitride," "sulfide," etc. refer to compounds containing, respectively, oxygen, carbon, nitrogen, sulfur, etc., the term "high-k dielectric" refers to a material having a higher dielectric constant (k) than silicon oxide, while the term "low-k dielectric" refers to a material having a lower k than silicon oxide. The terms "substantially," "close," "approximately," "near," and "about," generally refer to being within +/- 20%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 20%, e.g., within +/- 5% or within +/- 2%, of a target value based on the context of a particular value as described herein or as known in the art.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "on" a second layer is in direct contact with that second layer. Similarly, unless explicitly stated otherwise, one feature disposed between two features may be in direct contact with the adjacent features or may have one or more intervening layers.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. As used herein, the notation "A/B/C" means (A), (B), and/or (C).

Although certain elements may be referred to in the singular herein, such elements may include multiple sub-elements. For example, "an insulator material" may include one or more insulator materials. The term "insulating" and variations thereof (e.g., "insulative" or "insulator") means "electrically insulating," the term "conducting" and variations thereof (e.g., "conductive" or "conductor") means "electrically conducting," unless otherwise specified. For example, the term "insulator material" may refer to solid materials (and/or liquid materials that solidify after processing as described herein) that are substantially electrically non-conducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. With reference to optical signals and/or devices, components and elements that operate on or using optical signals, the term "conducting/conductive" can also mean "optically conducting/conductive."

The description may use the phrases "in an embodiment" or "in embodiments," which may each refer to one or more of the same or different embodiments. Furthermore, the terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

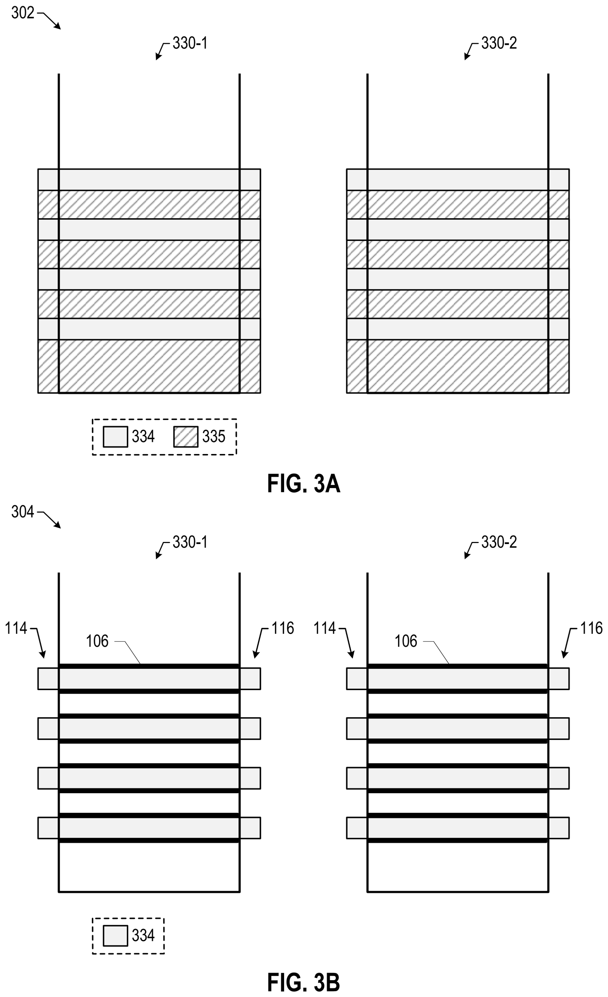

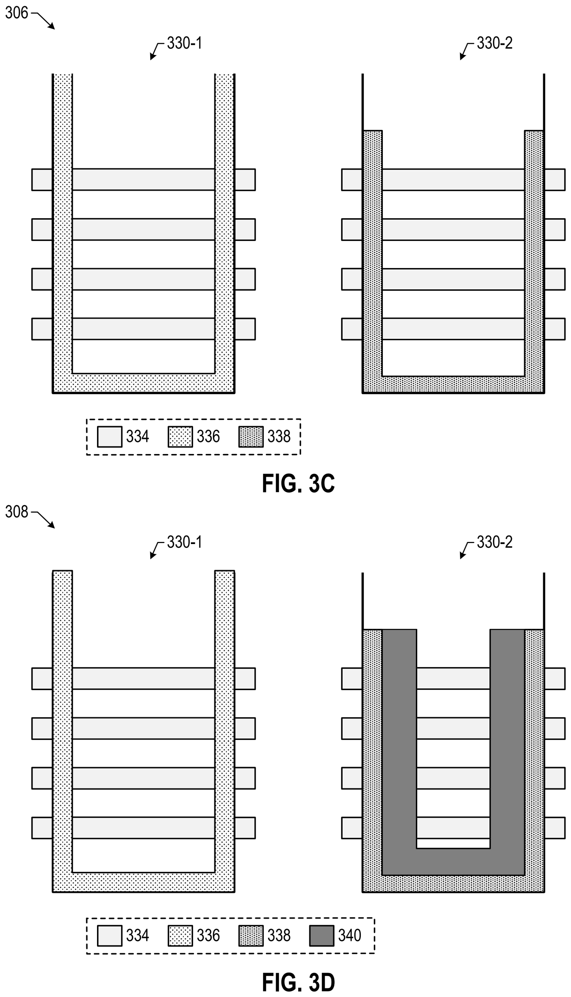

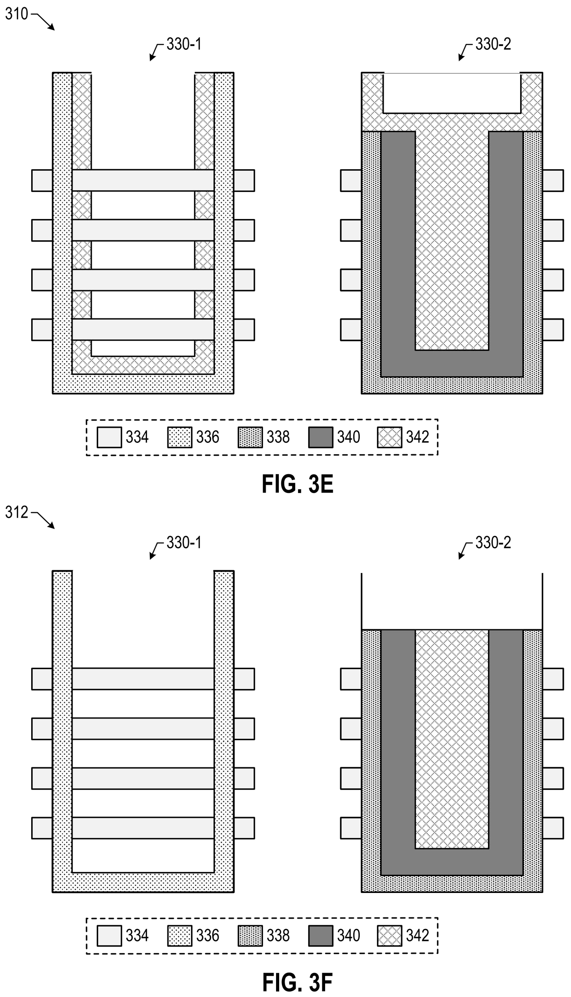

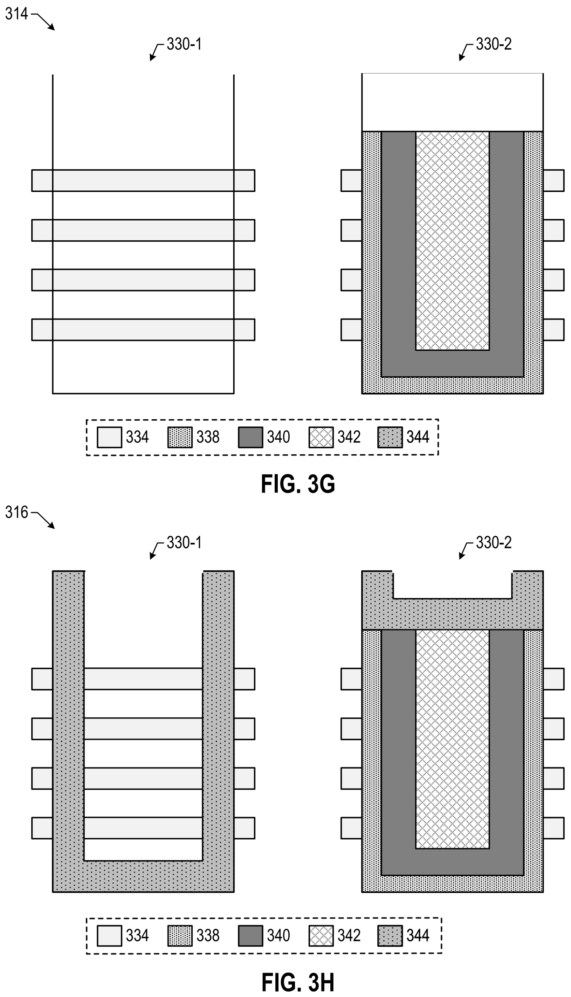

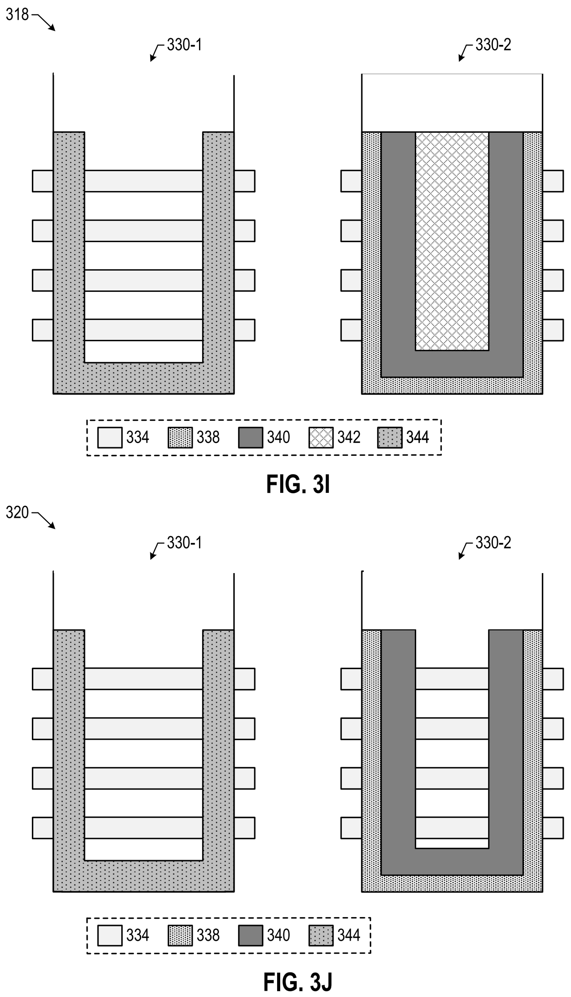

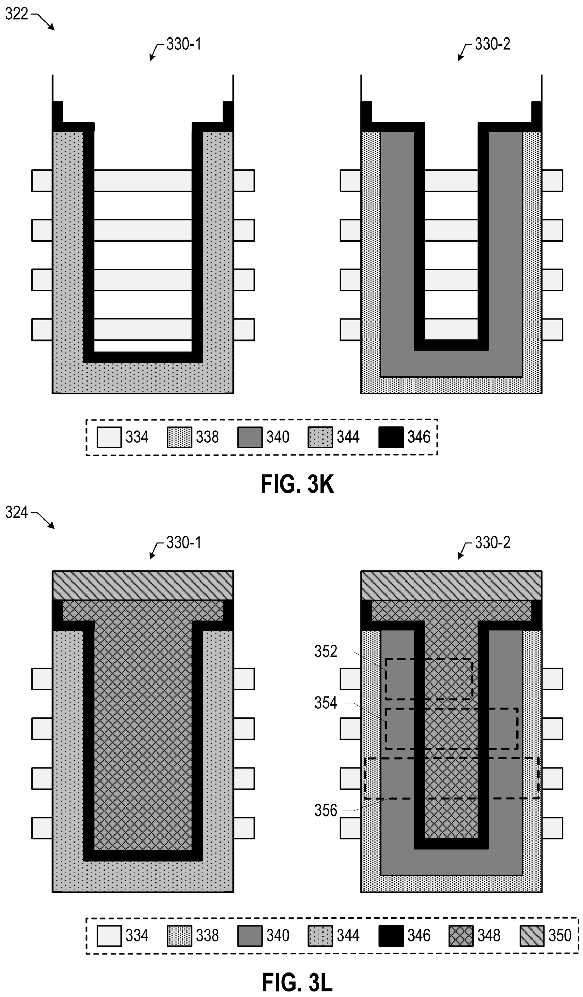

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. To not clutter the drawings, if multiple instances of certain elements are illustrated, only some of the elements may be labeled with a reference sign. A plurality of drawings with the same number and different letters may be referred to without the letters, e.g., FIGS. 3A-3L may be referred to as "FIG. 3."

In the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of IC structures with gates formed using the gate metallization method described herein.

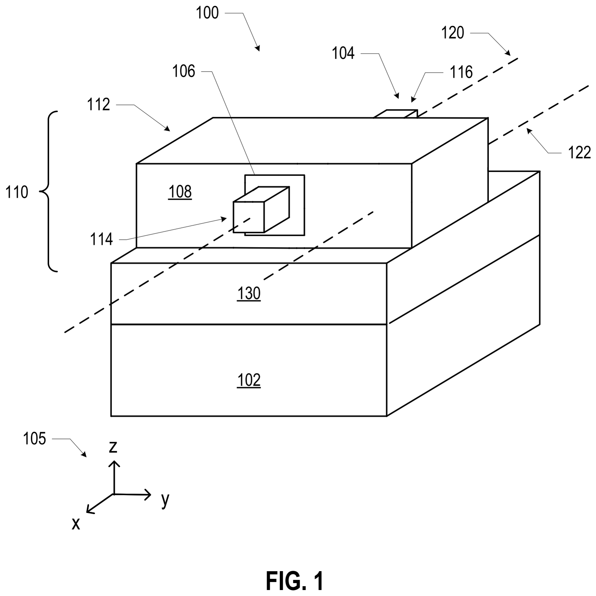

FIG. 1 provides a perspective view of an example IC structure 100 implementing a nanoribbon transistor 110 that may be fabricated using gate metallization described herein, in accordance with some embodiments. FIG. 1 is a perspective drawing, and an example coordinate system 105 (x-y-z coordinate system) is shown in FIG. 1 to assist explanations. Other drawings illustrating various axes (e.g., FIGS. 3A-3L) refer to the axes of the coordinate system 105.

Turning to the details of FIG. 1, the IC structure 100 may include a semiconductor material, which may include one or more semiconductor materials, formed as a nanoribbon 104 (i.e., an elongated semiconductor structure) extending substantially parallel to a base 102. The transistor 110 may be formed on the basis of the nanoribbon 104 by providing a gate stack 112 at least partially wrapping around a portion of the nanoribbon referred to as a "channel portion" and by providing S/D regions, shown in FIG. 1 as a first S/D region 114 and a second S/D region 116, on either side of the gate stack 112. In some embodiments, a layer of oxide material 130 may be provided between the base 102 and the gate stack 112/the nanoribbon 104. Although only a single nanoribbon 104 is shown in FIG. 1, in some embodiments, the IC structure 100 may include a stack of nanoribbons 104, where nanoribbons 104 are vertically stacked above one another, as known in the art. In such embodiments, the gate stack 112 may at least partially wrap around portions of multiple (e.g., all) nanoribbons 104 of the stack, and each of the first S/D region 114 and the second S/D region 116 may extend continuously throughout the stack, thus forming a single transistor 110 with channel portions in multiple nanoribbons 104 of the stack. One example implementation of transistors that include stacks of nanoribbons is shown in FIGS. 3A-3L.

The IC structure 100 shown in FIG. 1, as well as IC structures/devices shown in other drawings of the present disclosure, are intended to show relative arrangements of some of the components therein, and the IC structures/devices shown herein, or portions thereof, may include other components that are not illustrated. For example, electrical contacts to the S/D regions 114 and 116 of the transistor 110, and additional layers such as a spacer layer around the gate stack 112 of the transistor 110, etc., are not shown in FIG. 1. In another example, although not specifically illustrated in FIG. 1, a dielectric spacer may be provided between a first S/D contact that may be coupled to a first S/D region 114 of the transistor 110 and the gate stack 112 as well as between a second S/D contact that may be coupled to a second S/D region 116 of the transistor 110 and the gate stack 112 in order to provide electrical isolation between the source, gate, and drain contacts (in general, "contacts" described herein may also be referred to as "electrodes"). In yet another example, although not specifically illustrated in FIG. 1, at least portions of the transistor 110 may be surrounded in an insulator material, such as any suitable interlayer dielectric (ILD) material. In some embodiments, such an insulator material may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass. In other embodiments, the insulator material surrounding portions of the transistor 110 may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate.

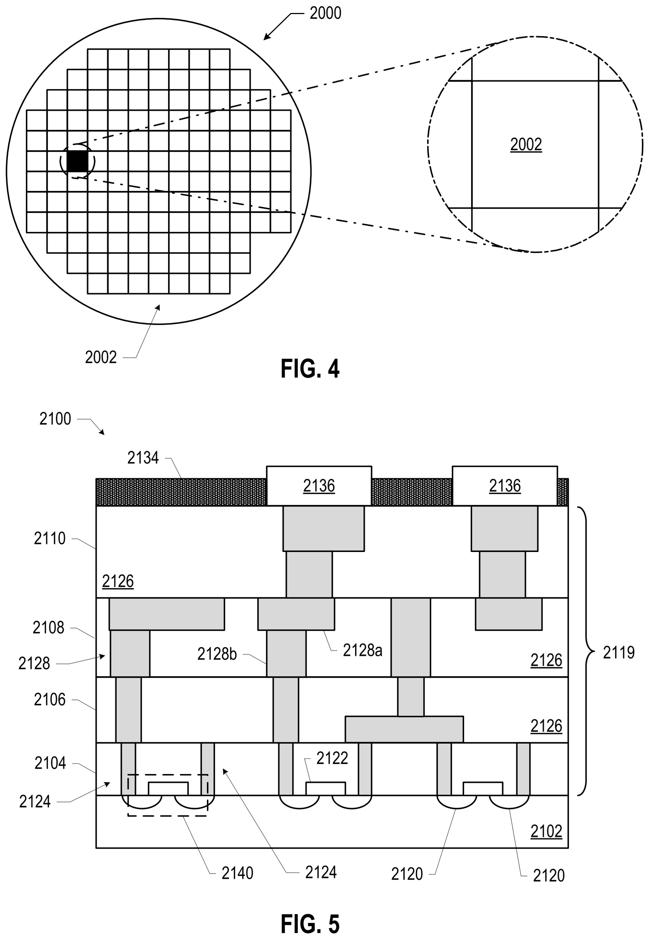

Implementations of the present disclosure may be formed or carried out on any suitable base 102, such as a substrate, a die, a wafer, or a chip. The base 102 may, e.g., be the wafer 2000 of FIG. 4, discussed below, and may be, or be included in, a die, e.g., the singulated die 2002 of FIG. 4, discussed below. The base 102 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the base 102 may be a printed circuit board (PCB) substrate. Although a few examples of materials from which the base 102 may be formed are described here, any material that may serve as a foundation upon which an IC structure with gates formed using the gate metallization method described herein may be built falls within the spirit and scope of the present disclosure. Although only one nanoribbon 104 is shown in FIG. 1, the IC structure 100 may include a stack of such nanoribbons where a plurality of nanoribbons 104 are stacked above one another, e.g., as is shown in FIGS. 3A-3L showing IC structures that may be examples of the IC structure 100. In some embodiments, a portion of the base 102 right below the lowest nanoribbon 104 of the stack may be shaped as a subfin extending away from a base, as is known in the field of nanoribbon transistors.

The nanoribbon 104 may take the form of a nanowire or nanoribbon, for example. In some embodiments, an area of a transverse cross-section of the nanoribbon 104 (i.e., an area in the y-z plane of the coordinate system 105) may be between about 25 and 10000 square nanometers, including all values and ranges therein (e.g., between about 25 and 1000 square nanometers, or between about 25 and 500 square nanometers). The transverse cross-section of the nanoribbon 104 is cross-section along a plane perpendicular to a longitudinal axis 120 of the nanoribbon 104, where the longitudinal axis 120 may, e.g., be along the x-axis of the coordinate system 105 and is shown in FIG. 1 with a dashed line. In some embodiments, a width of the nanoribbon 104 (i.e., a dimension measured in a plane parallel to the base 102 and in a direction perpendicular to the longitudinal axis 120, e.g., along the y-axis of the coordinate system 105) may be at least about 3 times larger than a thickness (or a "height") of the nanoribbon 104 (i.e., a dimension measured in a plane perpendicular to the base 102, e.g., along the z-axis of the coordinate system 105), including all values and ranges therein, e.g., at least about 4 times larger, or at least about 5 times larger.

Although the nanoribbon 104 illustrated in FIG. 1 is shown as having a square cross-section, or, more generally, a rectangular cross-section, the nanoribbon 104 may instead have a cross-section that is rounded at corners or otherwise irregularly shaped, and the gate stack 112 may conform to the shape of the nanoribbon 104. The terms "front face" and "back face" of a nanoribbon may refer to the faces of the nanoribbon 104 that are substantially parallel to the base 102, the term "sidewall" (or "side face") of a nanoribbon may refer to the opposing faces of the nanoribbon 104 that are substantially perpendicular to the base 102 and extend in a direction of the longitudinal axis 120 of the nanoribbon 104, while the term "end" of a nanoribbon may refer to the opposing faces of the nanoribbon 104 that are substantially perpendicular to the longitudinal axis 120 of the nanoribbon 104.

The nanoribbon 104 may be formed of one or more semiconductor materials, together referred to as a "channel material." In general, the channel material of the transistor 110, may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an NMOS transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a PMOS transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back-end fabrication to avoid damaging other components, e.g., front-end components such as the logic devices.

As noted above, the channel material may include IGZO. IGZO-based devices have several desirable electrical and manufacturing properties. IGZO has high electron mobility compared to other semiconductors, e.g., in the range of 20-50 times than amorphous silicon. Furthermore, amorphous IGZO (a-IGZO) transistors are typically characterized by high band gaps, low-temperature process compatibility, and low fabrication cost relative to other semiconductors. IGZO can be deposited as a uniform amorphous phase while retaining higher carrier mobility than oxide semiconductors such as zinc oxide. Different formulations of IGZO include different ratios of indium oxide, gallium oxide, and zinc oxide. One particular form of IGZO has the chemical formula InGaO₃(ZnO)₅. Another example form of IGZO has an indium:gallium:zinc ratio of 1:2:1. In various other examples, IGZO may have a gallium to indium ratio of 1:1, a gallium to indium ratio greater than 1 (e.g., 2:1, 3:1, 4:1, 5:1, 6:1, 7:1, 8:1, 9:1, or 10:1), and/or a gallium to indium ratio less than 1 (e.g., 1:2, 1:3, 1:4, 1:5, 1:6, 1:7, 1:8, 1:9, or 1:10). IGZO can also contain tertiary dopants such as aluminum or nitrogen.

As described above, in some embodiments, the transistor 110 may be a TFT. A TFT is a special kind of a FET made by depositing active semiconductor material over a base (e.g., a base as described above) that may be a non-conducting base. Some such materials may be deposited at relatively low temperatures, which allows depositing them within the thermal budgets imposed on back-end fabrication to avoid damaging the front-end components such as the logic devices of an IC device in which the transistor may be included. Thus, in some embodiments, the channel material of the transistor 110, may be a semiconductor material deposited at relatively low temperatures, and may include any of the thin-film materials, such as a high mobility oxide semiconductor materials, described above.

In other embodiments, instead of being deposited at relatively low temperatures as described above with reference to the TFTs, the channel material of the transistor 110 may be epitaxially grown in what typically involves relatively high-temperature processing. In such embodiments, the channel material may include any of the semiconductor materials described above, including oxide semiconductor materials. In some such embodiments, the channel material may be epitaxially grown directly on a semiconductor layer of a base over which the transistor will be fabricated, in a process known as "monolithic integration." In other such embodiments, the channel material of the transistor 110 may be epitaxially grown on a semiconductor layer of another base and then the epitaxially grown layer of the channel material may be transferred, in a process known as a "layer transfer," to a base over which the transistor will reside (e.g., the base 102), in which case the latter base may but does not have to include a semiconductor layer prior to the layer transfer. Layer transfer advantageously allows forming non-planar transistors, such as nanoribbon transistors, over bases or in layers that do not include semiconductor materials (e.g., in the back end of an IC device). Layer transfer also advantageously allows forming transistors of any architecture (e.g., non-planar or planar transistors) without imposing the negative effects of the relatively high-temperature epitaxial growth process on devices that may already be present over a base.

A channel material that is deposited at relatively low temperatures is typically a polycrystalline, polymorphous, or amorphous semiconductor, or any combination thereof. A channel material that is epitaxially grown is typically a highly crystalline (e.g., monocrystalline or single-crystalline) material. Therefore, whether the channel material of the transistor 110 is deposited at relatively low temperatures or epitaxially grown can be identified by inspecting grain size of the active portions of the channel material (e.g., of the portions of the channel material that form channels of transistors). An average grain size of a channel material of the transistor 110 being between about 0.5 and 1 millimeters (in which case the material may be polycrystalline) or smaller than about 0.5 millimeter (in which case the material may be polymorphous or amorphous) may be indicative of the channel material having been deposited (e.g., in which case the transistors in which such a channel material is included are TFTs). On the other hand, an average grain size of a channel material of the transistor 110 being equal to or greater than about 1 millimeter (in which case the material may be a single-crystal material) may be indicative of the channel material having been epitaxially grown and included in the final device either by monolithic integration or by layer transfer.

In some embodiments, the channel material of the transistor 110 may include a two-dimensional (2D) semiconductor material, i.e., a semiconductor material with a thickness of a few nanometers or less, where electrons in the material are free to move in the 2D plane but their restricted motion in the third direction is governed by quantum mechanics. In some such embodiments, such a channel material may include a single atomic monolayer of a 2D semiconductor material, while, in other such embodiments, such a channel material may include five or more atomic monolayers of a 2D semiconductor material. Examples of 2D materials that may be used to implement the channel material of any of the transistors described herein include, but are not limited to, graphene, hexagonal boron nitride, or transition-metal chalcogenides.

A gate stack 112 including a gate electrode material 108 and, optionally, a gate insulator 106, may wrap entirely or almost entirely around a portion of the nanoribbon 104 as shown in FIG. 1, with the channel portion of the transistor 110 being the active region (channel region) of the channel material in the portion of the nanoribbon 104 wrapped by the gate stack 112. As shown in FIG. 1, the gate insulator 106 may wrap around a transversal portion/cross-section of the nanoribbon 104, and the gate electrode material 108 may wrap around the gate insulator 106.

The gate electrode material 108 may include at least one PWF metal or NWF metal, depending on whether the transistor 110 is a PMOS transistor or an NMOS transistor. A PWF metal may be used as the gate electrode material 108 when the transistor 110 is a PMOS transistor and an NWF metal may be used as the gate electrode material 108 when the transistor 110 is an NMOS transistor. For a PMOS transistor, metals that may be used for the gate electrode material 108 may include, but are not limited to, ruthenium, palladium, platinum, cobalt, nickel, and conductive metal oxides (e.g., ruthenium oxide). For an NMOS transistor, metals that may be used for the gate electrode material 108 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 108 may include a stack of two or more metal layers, where one or more metal layers are work function metal layers and at least one metal layer is a fill metal layer. In particular, when the transistor 110 is fabricated using the gate metallization method described herein, the gate electrode material 108 will be a stack of multiple layers as shown in FIG. 3L for an example NMOS transistor and an example PMOS transistor. Further layers may be included next to the gate electrode material 108 for other purposes, such as to act as a diffusion barrier layer or/and an adhesion layer.

In some embodiments, the gate insulator 106 may include one or more high-k dielectrics including any of the materials discussed above with reference to the ILD that may surround portions of the transistor 110. In some embodiments, the high-k dielectric may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate insulator 106 may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In some embodiments, an annealing process may be carried out on the gate insulator 106 during fabrication of the transistor 110 to improve the quality of the gate insulator 106. The gate insulator 106 may have a thickness that may, in some embodiments, be between about 0.5 nanometers and 3 nanometers, including all values and ranges therein (e.g., between about 1 and 3 nanometers, or between about 1 and 2 nanometers), although, in other embodiments, the thickness of the gate insulator 106 may be greater than 3 nanometers. In some embodiments, the gate stack 112 may be surrounded by a gate spacer, not shown in FIG. 1. Such a gate spacer would be configured to provide separation between the gate stack 112 and S/D contacts (not shown) of the transistor 110 and could be made of a low-k dielectric material, some examples of which have been provided above. A gate spacer may include pores or air gaps to further reduce its dielectric constant.

Turning to the S/D regions 114, 116 of the transistor 110, in some embodiments, the S/D regions may be highly doped, e.g., with dopant concentrations of at least about 10²⁰ or at least about 10²¹ cm⁻³, in order to advantageously form Ohmic contacts with the respective S/D electrodes, although these regions may also have lower dopant concentrations and may form Schottky contacts in some implementations. Irrespective of the exact doping levels, the S/D regions of a transistor may be the regions having dopant concentration higher than in other regions, e.g., higher than a dopant concentration in the channel portion (i.e., in a channel material extending between the first S/D region 114 and the second S/D region 116), and, therefore, may be referred to as "highly doped" (HD) regions. The channel portion of the transistor 110 may include semiconductor materials with doping concentrations significantly smaller than those of the S/D regions 114, 116, e.g., with doping concentrations below 10¹⁸ cm⁻³ or below 10¹⁷ cm⁻³.

The S/D regions 114, 116 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114, 116. An epitaxial deposition process may then be carried out to fill the recesses with material that is used to fabricate the S/D regions 114, 116. In some implementations, the S/D regions 114, 116 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114, 116 may be formed using one or more alternate semiconductor materials such as germanium or a group III-V material or alloy. And in further embodiments, one or more layers of metal and/or metal alloys may be used to form the S/D regions 114, 116. In some embodiments, a distance between the first S/D region 114 and the second S/D regions 116 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

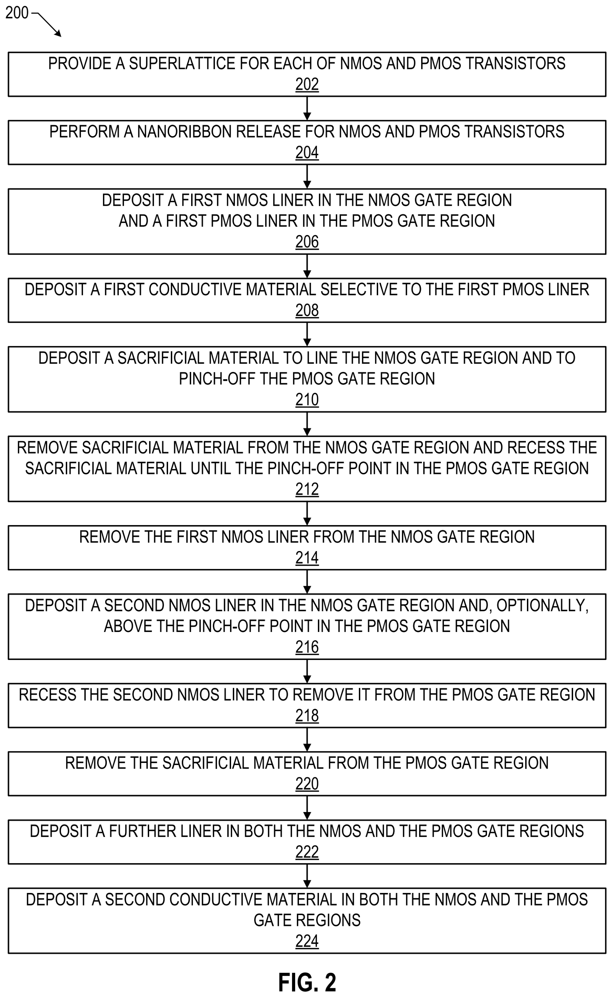

FIG. 2 is a flow diagram of a gate metallization method 200 for fabricating an IC structure, in accordance with some embodiments. FIGS. 3A-3L are cross-sectional side views illustrating example IC structures after various processes of the method of FIG. 2, in accordance with some embodiments. Each of FIGS. 3A-3L illustrates an IC structure with portions of two nanoribbon transistors, one of which is an NMOS transistor and the other one is a PMOS transistor, each implemented as a nanoribbon transistor with a stack of nanoribbons. For example, each of the two nanoribbon transistors of the IC structures of FIGS. 3A-3L may be implemented as the transistor 110 of FIG. 1, where the illustrations of FIGS. 3A-3L show cross-sectional side views along a plane that is substantially perpendicular to the base 102 and includes a line 122, shown in FIG. 1 (i.e., a cross-section along the gate stack 112 of the transistor with the nanoribbon 104 being in a plane behind the plane shown). Thus, each of FIGS. 3A-3L shows cross-sectional side views along x-z planes of the coordinate system 105 of FIG. 1. As described above, NMOS and PMOS transistors may be implemented on a single base (e.g., on a single die), and the IC structures shown in FIGS. 3A-3L are an example of that. In particular, the IC structures in each of FIGS. 3A-3L illustrate a gate region 330-1 and a gate region 330-2 (together referred to as "gate regions 330"), where the gate region 330-1 is a gate region of the NMOS transistor and the gate region 330-2 is a gate region of the PMOS transistor. While the gate regions 330-1 and 330-2 are shown side-by-side in each of FIGS. 3A-3L, this is only for ease of illustrations and does not imply that the gate regions 330-1 and 330-2 can necessarily be seen in a single cross-sectional plane. In fact, the gate region 330-1 may be a portion of an NMOS transistor such as a first transistor 110 with a longitudinal axis 120 extending along the x-axis at a first value along the y-axis, while the gate region 330-2 may be a portion of a PMOS transistor such as a second transistor 110 with a longitudinal axis 120 extending along the x-axis at a second value along the y-axis (i.e., the longitudinal axes 120 of the transistors with the gate regions 330-1 and 330-2 may be parallel to one another). The illustrations of FIGS. 3A-3L show the gate regions 330 to assist explanations of how cross-sections of the gate stack 112 along the plane with the line 122 may appear and may omit illustrations of other elements of the transistors besides the gate regions 330 (e.g., details of the S/D regions 114 and 116 on either side of each of the gate regions 330 are not shown). Furthermore, although various ones of FIGS. 3A-3L depict a particular number of nanoribbons 334 (e.g., four) in a stack of nanoribbons for each of the transistors represented by the gate regions 330, this is simply for ease of illustration, and IC structures may include more or fewer nanoribbons 334 in a stack of nanoribbons for each of the transistors. Some of the elements shown in FIGS. 3A-3L are referred to in the present description with reference numerals illustrated in these drawings with different patterns, with a legend showing the correspondence between the reference numerals and patterns being provided at the bottom of each drawing page of FIGS. 3A-3L. For example, different patterns are used in FIGS. 3A-3L to show nanoribbons 334, a second semiconductor material 335, etc.

Although the operations of the manufacturing method illustrated in FIG. 2 are illustrated once each and in a particular order, the operations may be performed in any suitable order and repeated as desired. For example, the example manufacturing method illustrated in FIG. 2 may include other operations not specifically shown in the drawings, such as various cleaning or planarization operations as known in the art. For example, in some embodiments, a base over which the IC structure is provided, as well as layers of various other materials subsequently deposited thereon, may be cleaned prior to, after, or during any of the processes of the manufacturing method illustrated in FIG. 2, e.g., to remove oxides, surface-bound organic and metallic contaminants, as well as subsurface contamination. In some embodiments, cleaning may be carried out using, e.g., a chemical solution (such as peroxide), and/or ultraviolet (UV) radiation combined with ozone, and/or oxidizing the surface (e.g., using thermal oxidation) then removing the oxide (e.g., using hydrofluoric acid (HF)). In another example, the arrangements/devices described herein may be planarized prior to, after, or during any of the processes of the manufacturing method illustrated in FIG. 2 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

The method 200 may begin with a process 202 that includes providing a superlattice for each of NMOS and PMOS transistors to be fabricated as transistors 110 over a single base such as the base 102. The superlattice may include a stack of first and second semiconductor materials alternating with one another. An IC structure 302, depicted in FIG. 3A, illustrates an example result of the process 202. As shown in FIG. 3A, in the IC structure 302, each of the transistors represented by the gate regions 330 may include a stack of a first semiconductor material that will later form nanoribbons 334 and a second semiconductor material 335 that will later be removed to release the nanoribbons 334 in the gate regions 330. The second semiconductor material 335 is a material that is etch-selective with respect to the first semiconductor material so that it may later be removed to separate different nanoribbons 334 of a given stack from one another. For example, the first semiconductor material (i.e., the semiconductor material of the nanoribbons 334) may be silicon, while the second semiconductor material 335 may be silicon germanium. More generally, the semiconductor material of the nanoribbons 334 may include any of the materials described with reference to the channel materials of the nanoribbon 104. Descriptions provided above with respect to the nanoribbon 104 are applicable to each of the nanoribbons 334, and therefore, in the interest of brevity, are not repeated. Each of the future transistors of the IC structure 302 will be based on a stack of four of the nanoribbons 334.

The method 200 may then continue with a process 204, in which a nanoribbon release is performed for NMOS and PMOS transistors of the IC structure 302. An IC structure 304, depicted in FIG. 3B, illustrates an example result of the process 204. As shown in FIG. 3B, in the IC structure 304, the second semiconductor material 335 is removed from the gate regions 330 (which are outlined by 3-sided boxes in this and other ones of FIGS. 3A-3L). Any suitable etch technique may be used in the process 204 to remove the second semiconductor material 335 in the gate regions 330 without substantially removing the semiconductor materials of the nanoribbons 334, due to etch selectivity between the second semiconductor material 335 and the semiconductor materials of the nanoribbons 334. FIG. 3B further illustrates that the gate insulator 106 may be deposited on the nanoribbons 334 after the nanoribbon release and before proceeding with further fabrication steps of forming the gate stacks 112 in the gate regions 330. FIG. 3B further illustrates that S/D regions 114 and 116 will be provided on either side of each of the gate regions 330, typically before formation of the gate stack 112, but possibly after formation of the gate stack 112. Details of the S/D regions 114 and 116 are not shown in FIG. 3A-3L to keep the focus on the gate regions 330, but the S/D regions 114 and 116 of the transistors with the gate regions 330 may be implemented as described for the transistor 110 of FIG. 1. The gate insulator 106 and the S/D regions 114 and 116 shown in FIG. 3B are not shown in subsequent drawings in order to not clutter the drawings, and it should be noted that, although the nanoribbons 334 are shown in FIGS. 3A-3L, the cross-sections of the x-z planes of the coordinate system 105, shown in FIGS. 3A-3L are along portions of the gate stacks 112 of the transistors outside of the nanoribbons 334 (i.e., along planes containing the line 122 of FIG. 1) and, thus, the nanoribbons 334 shown in FIGS. 3A-3L are actually in a plane behind the view of these cross-sections, but are shown for reference.

A process 206 of the method 200 may include depositing a first NMOS liner in the NMOS gate region (i.e., the gate region of an NMOS transistor) and a first PMOS liner in the PMOS gate region (i.e., the gate region of a PMOS transistor). An IC structure 306, depicted in FIG. 3C, illustrates an example result of the process 206. As shown in FIG. 3C, the IC structure 306 includes a first NMOS liner 336 in the NMOS gate region 330-1 and a first PMOS liner 338 in the PMOS gate region 330-2. The first NMOS liner 336 may include any material that is sufficiently etch-selective with respect to the first PMOS liner 338, a first conductive material 340 deposited in a process 208, and a sacrificial material 342 deposited in a process 210 of the method 200, so that, in a later process, the first NMOS liner 336 may be removed without substantially removing the first PMOS liner 338, the first conductive material 340, and the sacrificial material 342. In some embodiments, the first NMOS liner 336 may include a metal oxide, such as aluminum oxide (or, more generally, a material that includes a metal and oxygen, e.g., a material that includes aluminum and oxygen). In some embodiments, the first PMOS liner 338 may include a PWF material (i.e., a conductive material that includes a metal) such as titanium nitride (or, more generally, a material that includes titanium and nitrogen). The first NMOS liner 336 and the first PMOS liner 338 may be deposited in the process 206 using any suitable deposition technique that would line exposed portions of the sidewalls and bottoms of the gate regions 330, e.g., any suitable conformal deposition technique such as atomic layer deposition (ALD) or chemical vapor deposition (CVD). In some embodiments, a thickness of the first NMOS liner 336 and/or the first PMOS liner 338 deposited in the process 206 may be between about 2 nanometers and about 20 nanometers, e.g., between about 2 and 15 nanometers, or between about 2 and 10 nanometers. As shown in FIG. 3C, in some embodiments, the first PMOS liner 338 may be recessed in the gate region 330-2, relative to the first NMOS liner 336 in the gate region 330-1.

The method 200 may then proceed with a process 208, which may include depositing a first conductive material selective to the first PMOS liner of the IC structure 306. An IC structure 308, depicted in FIG. 3D, illustrates an example result of the process 208. As shown in FIG. 3D, in the IC structure 308, a layer of a first conductive material 340 deposited selectively (i.e., substantially only on) the first PMOS liner 338 in the PMOS gate region 330-2. Due to the selective deposition process, the first conductive material 340 is not present on the first NMOS liner 336 in the NMOS gate region 330-1. The first conductive material 340 may be deposited in the process 208 using any suitable selective deposition technique that would line the sidewalls and bottoms of the gate regions 330 that include the first PMOS liner 338 (i.e., of the gate region 330-2 of the IC structure 308), e.g., any suitable conformal deposition technique as described above. In various embodiments, the first conductive material 340 may include any suitable metal, metal alloy, or carbides or nitrides of one or more metals, that may be selectively deposited (e.g., only nucleate on) the first PMOS liner 338 but not on the first NMOS liner 336. In some embodiments, the first conductive material 340 may include tungsten (which may be referred to as "selective tungsten" because it is deposited selectively on the first PMOS liner 338). In some embodiments, a thickness of the first conductive material 340 deposited in the process 208 may be between about 5 nanometers and about 30 nanometers, e.g., between about 5 and 20 nanometers, or between about 5 and 15 nanometers. Importantly, in contrast to conventional gate metallization techniques, the first conductive material 340 only lines sidewalls and bottom of the gate region 330-2 where the first PMOS liner 338 is present, but does not pinch off the opening for the gate region 330-2.

The method 200 may further proceed with a process 210, in which a sacrificial material is deposited into the gate regions 330 of the IC structure 308 such that the sacrificial material lines the sidewalls and bottom of the NMOS gate region and pinches off the PMOS gate region. An IC structure 310, depicted in FIG. 3E, illustrates an example result of the process 210. As shown in FIG. 3E, a sacrificial material 342 is deposited into the gate regions 330 such that the sacrificial material 340 lines the sidewalls and bottom of the gate region 330-1 and pinches off (e.g., completely closes or seals) the gate region 330-2. The sacrificial material 342 may be deposited in the process 210 using any suitable deposition technique that would line the sidewalls and bottoms of the gate region 330-1 and pinch-off the gate region 330-2, e.g., any suitable conformal deposition technique as described above. The sacrificial material 342 may include any material that is sufficiently etch-selective with respect to the first PMOS liner 338 and the first conductive material 340 (and, possibly, with respect to a second NMOS liner 344 deposited in a process 216 of the method 200), so that, in a later process, the sacrificial material 342 may be removed without substantially removing the first PMOS liner 338, the first conductive material 340, and the second NMOS liner 344. In some embodiments, the sacrificial material 342 may include amorphous carbon.

Next, the method 200 may include a process 212 that includes removing the sacrificial material deposited in the process 210 from the NMOS gate region and recessing the sacrificial material until the pinch-off point in the PMOS gate region. An IC structure 312, depicted in FIG. 3F, illustrates an example result of the process 212. As shown in FIG. 3F, the sacrificial material 342 is no longer present in the gate region 330-1 and, in the gate region 330-2, the sacrificial material 342 only fills the remaining space between sidewalls of the first conductive material 340. For example, at this point, the top of the sacrificial material 342 in the gate region 330-2 may be substantially aligned with the top of the first conductive material 340 and the top of the first PMOS liner 338, as shown in FIG. 3F. In some embodiments, removal of the sacrificial material 342 in the process 212 may include any suitable etching technique.

The method 200 may further proceed with a process 214, in which the first NMOS liner deposited in the process 206 is removed from the NMOS gate region. An IC structure 314, depicted in FIG. 3G, illustrates an example result of the process 214. As shown in FIG. 3F, the sacrificial material 342 is no longer present in the gate region 330-1 and, in the gate region 330-2, the sacrificial material 342 only fills the remaining space between sidewalls of the first conductive material 340. For example, at this point, the top of the sacrificial material 342 in the gate region 330-2 may be substantially aligned with the top of the first conductive material 340 and the top of the first PMOS liner 338, as shown in FIG. 3F. In some embodiments, removal of the sacrificial material 342 in the process 212 may include any suitable etching technique.

Next, a process 216 of the method 200 may include depositing a second NMOS liner. An IC structure 316, depicted in FIG. 3H, illustrates an example result of the process 216. As shown in FIG. 3H the IC structure 316 includes a second NMOS liner 344 lining sidewalls and bottom of the NMOS gate region 330-1, and some of the second NMOS liner 344 may, optionally, be also deposited above the pinch-off point in the PMOS gate region 330-2. In some embodiments, the second NMOS liner 344 may include an NWF material (i.e., a conductive material that includes a metal) such as a conductive material comprising titanium, aluminum and carbon, or a conductive material comprising niobium, aluminum and carbon. The second NMOS liner 344 may be deposited in the process 216 using any suitable deposition technique that would line the sidewalls and bottoms of the gate regions 330, e.g., any suitable conformal deposition technique described above. In some embodiments, a thickness of the second NMOS liner 344 in the gate region 330-1 may be between about 2 nanometers and about 20 nanometers, e.g., between about 2 and 15 nanometers, or between about 2 and 10 nanometers. Because the sacrificial material 342 fills the gate region 330-2 to the pinch-off point, none of the second NMOS liner 344 is deposited in the proximity of the nanoribbons 334, where the gate stack 112 of the PMOS transistor will be, which may help preserve the threshold voltage and performance of the PMOS transistor. Some of the second NMOS liner 344 may happen to be deposited above the pinch-off point in the PMOS gate region 330-2, but that portion may easily be removed in a subsequent process (in the process 218).

The method 200 may further proceed with a process 218 that includes recessing the second NMOS liner deposited in the process 216 in order to remove it from the PMOS gate region. An IC structure 318, depicted in FIG. 3I, illustrates an example result of the process 218. As shown in FIG. 3I, the second NMOS liner 344 is no longer present in the gate region 330-2 and, in the gate region 330-1, the second NMOS liner 344 is recessed. For example, at this point, the top of the second NMOS liner 344 in the gate region 330-1 may be substantially aligned with the top of the first conductive material 340, the top of the sacrificial material 342, and the top of the first PMOS liner 338, as shown in FIG. 3I. In some embodiments, recessing the second NMOS liner 344 in the process 218 may include any suitable etching technique.

Next, the method 200 may include a process 220, in which the sacrificial material 342 is removed from the PMOS gate region. An IC structure 320, depicted in FIG. 3J, illustrates an example result of the process 220. As shown in FIG. 3J, the sacrificial material 342 is no longer present in the gate region 330-2. In some embodiments, removing the sacrificial material 342 in the process 220 may include any suitable etching technique, e.g., selectively etching out the sacrificial material 342 without substantially etching other materials of the IC structure 320.

The method 200 may further include a process 222 that includes depositing a further liner in both the NMOS and the PMOS gate regions. An IC structure 322, depicted in FIG. 3K, illustrates an example result of the process 222. As shown in FIG. 3K, the IC structure 322 includes a further liner 346 lining all open surfaces in the gate regions 330. FIG. 3K further illustrates that, in some embodiments, the further liner 346 may be slightly recessed after deposition. In some embodiments, the further liner 346 may include a PWF material (i.e., a conductive material that includes a metal) such as titanium nitride (or, more generally, a material that includes titanium and nitrogen). In some embodiments, the first PMOS liner 338 and the further liner 346 may have substantially the same material composition. In other embodiments, material compositions the first PMOS liner 338 and the further liner 346 may be different. The further liner 346 may be deposited in the process 222 using any suitable deposition technique that would line exposed portions of the sidewalls and bottoms of the gate regions 330, e.g., any suitable conformal deposition technique such as any of those described above. In some embodiments, a thickness of the further liner 346 deposited in the process 222 may be between about 2 nanometers and about 20 nanometers, e.g., between about 2 and 15 nanometers, or between about 2 and 10 nanometers.

The method 200 may conclude with a process 224, which may include depositing a second conductive material in both the NMOS and the PMOS gate regions. An IC structure 324, depicted in FIG. 3L, illustrates an example result of the process 224. As shown in FIG. 3L, in the IC structure 324, a second conductive material 348 is deposited selectively (i.e., substantially only on) the further liner 346 in the NMOS gate region 330-1 and in the PMOS gate region 330-2. Due to the selective deposition process, the second conductive material 348 is not present beyond the further liner 346. The second conductive material 348 may be deposited in the process 224 using any suitable selective deposition technique that would line the sidewalls and bottoms of the gate regions 330 that include the further liner 346, e.g., any suitable conformal deposition technique as described above. In various embodiments, the second conductive material 348 may include any suitable metal, metal alloy, or carbides or nitrides of one or more metals, that may be selectively deposited (e.g., only nucleate on) the further liner 346. In some embodiments, the second conductive material 348 may include tungsten (which may be referred to as "selective tungsten" because it is deposited selectively on the further liner 346). In some embodiments, the first conductive material 340 and the second conductive material 348 may have substantially the same material composition. In other embodiments, material compositions the first conductive material 340 and the second conductive material 348 may be different. In some embodiments, the second conductive material 348 may substantially completely fill the gate regions 330 lined with the further liner 346. FIG. 3L further illustrates that, in some embodiments, a third conductive material 350 may be deposited above the second conductive material 348 and the further liner 346 in the gate regions 330, e.g., to serve as a gate contact. The third conductive material 350 may include any of the conductive materials described herein. In various embodiments, the second conductive material 348 and the third conductive material 350 may be deposited using any suitable deposition technique.

As a result of using the fabrication method 200, final IC structures will have certain unique features in the gate regions 330 that differentiate them from conventional IC structures implementing nanoribbon stacks. In particular, at least a portion of the gate electrode material 108 in the gate stack 112 of a PMOS transistor of an IC structure will include multiple layers of conductive materials as shown in the gate region 330-2 of the IC structure 324 of FIG. 3L. For example, viewed from one perspective, as a result of using the method 200, the gate region 330-2 includes at least a stack 352 of three layers within a dashed contour shown in FIG. 3L. The stack 352 includes a portion of the first conductive material 340 to the left of the second conductive material 348, a portion of the further liner 346 to the left of the second conductive material 348, and the second conductive material 348. Viewed from another perspective, as a result of using the method 200, the gate region 330-2 includes at least a stack 354 of five layers within another dashed contour shown in FIG. 3L. The stack 354 includes a first layer that includes a portion of the first conductive material 340 to the left of the second conductive material 348, a second layer that includes a portion of the further liner 346 to the left of the second conductive material 348, a third layer that includes the second conductive material 348, a fourth layer that includes a portion of the further liner 346 to the right of the second conductive material 348, and a fifth layer that includes a portion of the first conductive material 340 to the right of the second conductive material 348. Viewed from yet another perspective, as a result of using the method 200, the gate region 330-2 includes a stack 356 of seven layers within yet another dashed contour shown in FIG. 3L. The stack 356 includes a first layer that includes a portion of the first PMOS liner 338 to the left of the second conductive material 348, a second layer that includes a portion of the first conductive material 340 to the left of the second conductive material 348, a third layer that includes a portion of the further liner 346 to the left of the second conductive material 348, a fourth layer that includes the second conductive material 348, a fifth layer that includes a portion of the further liner 346 to the right of the second conductive material 348, a sixth layer that includes a portion of the first conductive material 340 to the right of the second conductive material 348, and a seventh layer that includes a portion of the first PMOS liner 338 to the right of the second conductive material 348. Various ones of these layers may be viewed as stacked in a direction that is substantially parallel to a longitudinal axis of the nanoribbons 334 (or, for the transistor 110, substantially parallel to the longitudinal axis 120). Because of how these layers were fabricated in the method 200, material compositions of some pairs of the layers will be substantially the same and material compositions of some other pairs of the layers will be different. For example, for the stack 356 (which encompasses layers of the stack 354 and layers of the stack 352), material compositions of the first and seventh layers will be substantially the same because those layers are deposited in a single process 206 of the method 200, material compositions of the second and sixth layers will be substantially the same because those layers are deposited in a single process 208 of the method 200, and material compositions of the third and fifth layers will be substantially the same because those layers are deposited in a single process 222 of the method 200. On the other hand, material compositions of the second and sixth layers of the stack 356 will be different from material compositions of the first and seventh layers of the stack 356. Similarly, material compositions of the third and fifth layers of the stack 356 will be different from material compositions of the second and sixth layers of the stack 356. In some embodiments, material compositions of the second and sixth layers of the stack 356 may be substantially the same as a material composition of the fourth layer of the stack 356. In some embodiments, material compositions of the first and seventh layers of the stack 356 may be substantially the same as material compositions of the third and fifth layers of the stack 356.

IC structures with gates formed using the gate metallization method described herein, e.g., IC structures according to any embodiments described with reference to FIGS. 1-3, or any combination of such embodiments, may be included in any suitable electronic device. FIGS. 4-9 illustrate various examples of apparatuses that may include one or more IC structures with gates formed using the gate metallization method described herein (e.g., any embodiments of the IC structure 100 or any embodiments of the IC structure 324, described herein).

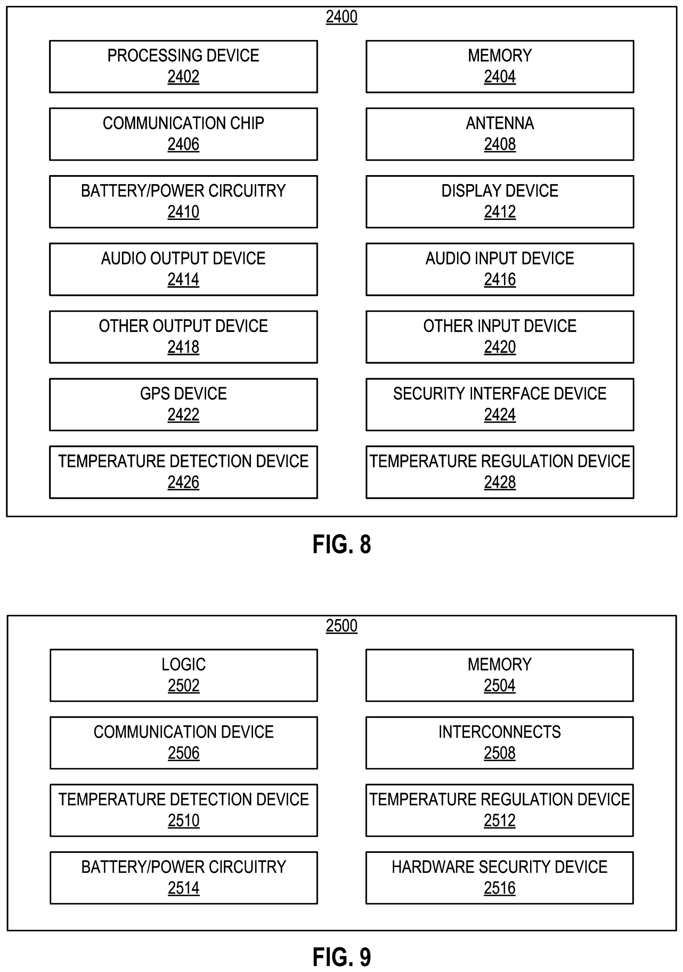

FIG. 4 illustrates top views of a wafer and dies that may include one or more IC structures with gates formed using the gate metallization method described herein, in accordance with some embodiments. The wafer 2000 may be composed of semiconductor material and may include one or more dies 2002 having IC structures formed on a surface of the wafer 2000. Each of the dies 2002 may be a repeating unit of a semiconductor product that includes any suitable IC structure (e.g., any of the IC structures described with reference to FIGS. 1-3). After the fabrication of the semiconductor product is complete (e.g., after manufacture of one or more IC structures as described herein), the wafer 2000 may undergo a singulation process in which each of the dies 2002 is separated from one another to provide discrete "chips" of the semiconductor product. In particular, devices that include one or more IC structures as disclosed herein may take the form of the wafer 2000 (e.g., not singulated) or the form of the die 2002 (e.g., singulated). The die 2002 may include one or more transistors with gates formed using the gate metallization method described herein and/or supporting circuitry to route electrical signals to the transistors, as well as any other IC components. In some embodiments, the wafer 2000 or the die 2002 may include a memory device (e.g., a memory device with one or more transistors with gates formed using the gate metallization method described herein), a logic device (e.g., an AND, OR, NAND, or NOR gate, where any of the gates may include one or more transistors with gates formed using the gate metallization method described herein), or any other suitable circuit element. Multiple ones of these devices may be combined on a single die 2002. For example, a memory array formed by multiple memory devices may be formed on a same die 2002 as a processing device (e.g., the processing device 2500 of FIG. 9) or other logic that is configured to store information in the memory devices or execute instructions stored in the memory array.

FIG. 5 is a side, cross-sectional view of an IC device 2100 that may include one or more IC structures with gates formed using the gate metallization method described herein, in accordance with some embodiments. For example, any of the transistors 2140 of the IC device 2100 may be implemented as any of the transistors with gates formed using the gate metallization method described herein. In another example, one or more of the IC devices 2100 may be included in one or more dies 2002 of FIG. 4. The IC device 2100 may be formed on a substrate 2102 (e.g., the wafer 2000 of FIG. 4) and may be included in a die (e.g., the die 2002 of FIG. 4). The substrate 2102 may take on any forms of the base 102, described above.

The IC device 2100 may include one or more device layers 2104 disposed on the substrate 2102. The device layer 2104 may include features of one or more transistors 2140 (e.g., MOSFETs) formed on the substrate 2102. The device layer 2104 may include, for example, one or more S/D regions 2120, a gate 2122 to control current flow in the transistors 2140 between the S/D regions 2120, and one or more S/D contacts 2124 to route electrical signals to/from the S/D regions 2120. The transistors 2140 may include additional features not depicted for the sake of clarity, such as device isolation regions, gate contacts, and the like. The transistors 2140 are not limited to the type and configuration depicted in FIG. 5 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or GAA transistors, such as nanoribbon and nanowire transistors.

Each transistor 2140 may include a gate 2122 formed of at least two layers, a gate insulator and a gate electrode. The gate insulator of the transistor 2140 may be implemented as the gate insulator 106, while the gate electrode of the transistor 2140 may be implemented as the gate electrode material 108, described above. For those of the transistors 2140 that are fabricated using the gate metallization method described herein, the gate 2122 may be implemented as described with reference to FIGS. 3A-3L.

The S/D regions 2120 may be formed within the substrate 2102 adjacent to the gate 2122 of each transistor 2140. The S/D regions 2120 of the transistor 2140 may be implemented as the S/D regions 114 and 116, described above.

Electrical signals, such as power and/or input/output (I/O) signals, may be routed to and/or from the devices (e.g., the transistors 2140) of the device layer 2104 through one or more interconnect layers disposed on the device layer 2104 (illustrated in FIG. 5 as interconnect layers 2106, 2108, and 2110). For example, electrically conductive features of the device layer 2104 (e.g., the gate 2122 and the S/D contacts 2124) may be electrically coupled with the interconnect structures 2128 of the interconnect layers 2106, 2108, and 2110. The one or more interconnect layers 2106, 2108, and 2110 may form a metallization stack (also referred to as an "ILD stack") 2119 of the IC device 2100.

The interconnect structures 2128 may be arranged within the interconnect layers 2106, 2108, and 2110 to route electrical signals according to a wide variety of designs (in particular, the arrangement is not limited to the particular configuration of interconnect structures 2128 depicted in FIG. 5). Although a particular number of interconnect layers 2106, 2108, and 2110 is depicted in FIG. 5, embodiments of the present disclosure include IC devices having more or fewer interconnect layers than depicted.

In some embodiments, the interconnect structures 2128 may include conductive lines 2128a and/or conductive vias 2128b filled with an electrically conductive material such as a metal. The conductive lines 2128a may be arranged to route electrical signals in a direction of a plane that is substantially parallel with a surface of the substrate 2102 upon which the device layer 2104 is formed. For example, the conductive lines 2128a may route electrical signals in a direction in and out of the page from the perspective of FIG. 5. The conductive vias 2128b may be arranged to route electrical signals in a direction of a plane that is substantially perpendicular to the surface of the substrate 2102 upon which the device layer 2104 is formed. In some embodiments, the conductive vias 2128b may electrically couple conductive lines 2128a of different interconnect layers 2106, 2108, and 2110 together.

The interconnect layers 2106, 2108, and 2110 may include an insulator material 2126 disposed between the interconnect structures 2128, as shown in FIG. 5. In some embodiments, the insulator material 2126 disposed between the interconnect structures 2128 in different ones of the interconnect layers 2106, 2108, and 2110 may have different compositions; in other embodiments, the composition of the insulator material 2126 between different interconnect layers 2106, 2108, and 2110 may be the same.

A first interconnect layer 2106 may be formed above the device layer 2104. In some embodiments, the first interconnect layer 2106 may include conductive lines 2128a and/or conductive vias 2128b, as shown. The conductive lines 2128a of the first interconnect layer 2106 may be coupled with contacts (e.g., the S/D contacts 2124) of the device layer 2104.

A second interconnect layer 2108 may be formed above the first interconnect layer 2106. In some embodiments, the second interconnect layer 2108 may include conductive vias 2128b to couple the conductive lines 2128a of the second interconnect layer 2108 with the conductive lines 2128a of the first interconnect layer 2106. Although the conductive lines 2128a and the conductive vias 2128b are structurally delineated with a line within each interconnect layer (e.g., within the second interconnect layer 2108) for the sake of clarity, the conductive lines 2128a and the conductive vias 2128b may be structurally and/or materially contiguous (e.g., simultaneously filled during a dual-damascene process) in some embodiments.

A third interconnect layer 2110 (and additional interconnect layers, as desired) may be formed in succession on the second interconnect layer 2108 according to similar techniques and configurations described in connection with the second interconnect layer 2108 or the first interconnect layer 2106. In some embodiments, the interconnect layers that are "higher up" in the metallization stack 2119 in the IC device 2100 (i.e., farther away from the device layer 2104) may be thicker.

The IC device 2100 may include a solder resist material 2134 (e.g., polyimide or similar material) and one or more conductive contacts 2136 formed on the interconnect layers 2106, 2108, and 2110. In FIG. 5, the conductive contacts 2136 are illustrated as taking the form of bond pads. The conductive contacts 2136 may be electrically coupled with the interconnect structures 2128 and configured to route the electrical signals of the transistor(s) 2140 to other external devices. For example, solder bonds may be formed on the one or more conductive contacts 2136 to mechanically and/or electrically couple a chip including the IC device 2100 with another component (e.g., a circuit board). The IC device 2100 may include additional or alternate structures to route the electrical signals from the interconnect layers 2106, 2108, and 2110; for example, the conductive contacts 2136 may include other analogous features (e.g., posts) that route the electrical signals to external components.

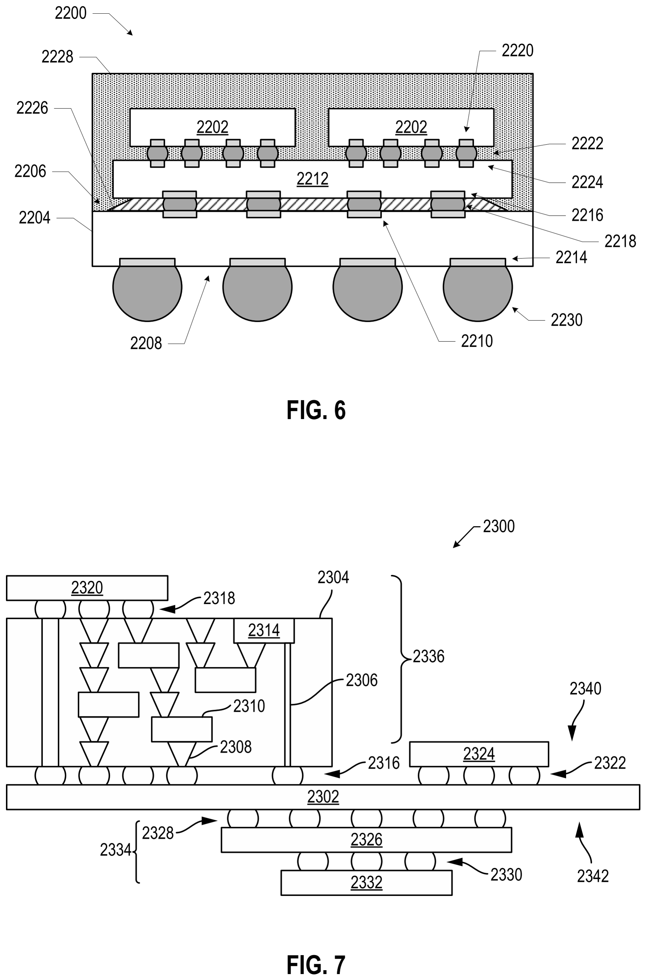

FIG. 6 is a side, cross-sectional view of an example IC package 2200 that may include one or more IC structures with gates formed using the gate metallization method described herein, in accordance with some embodiments. For example, any of the dies 2202 of the IC package 2200 may be implemented as the die 2002 of FIG. 4. In another example, any of the dies 2202 may include any of the embodiments of the IC device 2100 of FIG. 5. In embodiments in which the IC package 2200 includes multiple dies 2202, the IC package 2200 may be referred to as a multi-chip package (MCP). The dies 2202 may include circuitry to perform any desired functionality. For example, or more of the dies 2202 may be logic dies (e.g., silicon-based dies), and one or more of the dies 2202 may be memory dies (e.g., high bandwidth memory). In some embodiments, the IC package 2200 may be a system-in-package (SiP). In some embodiments, the IC package 2200 may include a photonics IC (PIC) co-packaged with an IC package. In some embodiments, the IC package 2200 may include fully integrated electronic photonics ICs (EPICs).

The IC package 2200 may include a package substrate 2204 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 2206 and the face 2208, or between different locations on the face 2206, and/or between different locations on the face 2208. These conductive pathways may take the form of any of the interconnect structures 2128 discussed above with reference to FIG. 5.

The package substrate 2204 may include conductive contacts 2210 that are coupled to conductive pathways (not shown) through the package substrate 2204, allowing circuitry within the dies 2202 and/or the interposer 2212 to electrically couple to various ones of the conductive contacts 2214 (or to other devices included in the package substrate 2204, not shown).
The IC package 2200 may include an interposer 2212 coupled to the package substrate 2204 via conductive contacts 2216 of the interposer 2212, first-level interconnects 2218, and the conductive contacts 2210 of the package substrate 2204. The first-level interconnects 2218 illustrated in FIG. 6 are solder bumps, but any suitable first-level interconnects 2218 may be used. In some embodiments, no interposer 2212 may be included in the IC package 2200; instead, the dies 2202 may be coupled directly to the conductive contacts 2210 at the face 2206 by first-level interconnects 2218. Generally, one or more dies 2202 may be coupled to the package substrate 2204 via any suitable structure (e.g., a silicon bridge, an organic bridge, one or more waveguides, one or more interposers, wirebonds, etc.).

The IC package 2200 may include one or more dies 2202 coupled to the interposer 2212 via conductive contacts 2220 of the dies 2202, first-level interconnects 2222, and conductive contacts 2224 of the interposer 2212. The conductive contacts 2224 may be coupled to conductive pathways (not shown) through the interposer 2212, allowing circuitry within the dies 2202 to electrically couple to various ones of the conductive contacts 2216 (or to other devices included in the interposer 2212, not shown). The first-level interconnects 2222 illustrated in FIG. 6 are solder bumps, but any suitable first-level interconnects 2222 may be used. For example, the first-level interconnects 2222 may include hybrid bonding interconnects. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

In some embodiments, an underfill material 2226 may be disposed between the package substrate 2204 and the interposer 2212 around the first-level interconnects 2218, and a mold compound 2228 may be disposed around the dies 2202 and the interposer 2212 and in contact with the package substrate 2204. In some embodiments, the underfill material 2226 may be the same as the mold compound 2228. Example materials that may be used for the underfill material 2226 and the mold compound 2228 are epoxy mold materials, as suitable. Second-level interconnects 2230 may be coupled to the conductive contacts 2214. The second-level interconnects 2230 illustrated in FIG. 6 are solder balls (e.g., for a ball grid array arrangement), but any suitable second-level interconnects 2230 may be used (e.g., pins in a pin grid array arrangement or lands in a land grid array arrangement). The second-level interconnects 2230 may be used to couple the IC package 2200 to another component, such as a circuit board (e.g., a motherboard), an interposer, or another IC package, as known in the art and as discussed below with reference to FIG. 7.

Although the IC package 2200 illustrated in FIG. 6 is a flip chip package, other package architectures may be used. For example, the IC package 2200 may be a ball grid array (BGA) package, such as an embedded wafer-level ball grid array (eWLB) package. In another example, the IC package 2200 may be a wafer-level chip scale package (WLCSP) or a panel fanout (FO) package. Although two dies 2202 are illustrated in the IC package 2200 of FIG. 6, an IC package 2200 may include any desired number of dies 2202. An IC package 2200 may include additional passive components, such as surface-mount resistors, capacitors, and inductors disposed on the first face 2206 or the second face 2208 of the package substrate 2204, or on either face of the interposer 2212. More generally, an IC package 2200 may include any other active or passive components known in the art.

FIG. 7 is a side, cross-sectional view of an IC device assembly 2300 that may include one or more IC packages or other electronic components (e.g., a die) including one or more IC structures with gates formed using the gate metallization method described herein, in accordance with some embodiments. The IC device assembly 2300 includes a number of components disposed on a circuit board 2302 (which may be, e.g., a motherboard). The IC device assembly 2300 includes components disposed on a first face 2340 of the circuit board 2302 and an opposing second face 2342 of the circuit board 2302; generally, components may be disposed on one or both faces 2340 and 2342. Any of the IC packages discussed below with reference to the IC device assembly 2300 may take the form of any of the embodiments of the IC package 2200 discussed above with reference to FIG. 6.

In some embodiments, the circuit board 2302 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate.

The IC device assembly 2300 illustrated in FIG. 7 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302 and may include solder balls (as shown in FIG. 7), male and female portions of a socket, an adhesive, an underfill material, and/or any other suitable electrical and/or mechanical coupling structure.

The package-on-interposer structure 2336 may include an IC package 2320 coupled to a package interposer 2304 by coupling components 2318. The coupling components 2318 may take any suitable form for the application, such as the forms discussed above with reference to the coupling components 2316. Although a single IC package 2320 is shown in FIG. 7, multiple IC packages may be coupled to the package interposer 2304; indeed, additional interposers may be coupled to the package interposer 2304. The package interposer 2304 may provide an intervening substrate used to bridge the circuit board 2302 and the IC package 2320. The IC package 2320 may be or include, for example, a die (the die 2002 of FIG. 4), an IC device (e.g., the IC device 2100 of FIG. 5), or any other suitable component. Generally, the package interposer 2304 may spread a connection to a wider pitch or reroute a connection to a different connection. For example, the package interposer 2304 may couple the IC package 2320 (e.g., a die) to a set of BGA conductive contacts of the coupling components 2316 for coupling to the circuit board 2302. In the embodiment illustrated in FIG. 7, the IC package 2320 and the circuit board 2302 are attached to opposing sides of the package interposer 2304; in other embodiments, the IC package 2320 and the circuit board 2302 may be attached to a same side of the package interposer 2304. In some embodiments, three or more components may be interconnected by way of the package interposer 2304. In some embodiments, the IC package 2320 may include one or more IC structures with gates formed using the gate metallization method described herein.

In some embodiments, the package interposer 2304 may be formed as a PCB, including multiple metal layers separated from one another by layers of dielectric material and interconnected by electrically conductive vias. In some embodiments, the package interposer 2304 may be formed of an epoxy resin, a fiberglass-reinforced epoxy resin, an epoxy resin with inorganic fillers, a ceramic material, or a polymer material such as polyimide. In some embodiments, the package interposer 2304 may be formed of alternate rigid or flexible materials that may include the same materials described above for use in a semiconductor substrate, such as silicon, germanium, and other group III-V and group IV materials. The package interposer 2304 may include metal lines 2310 and vias 2308, including but not limited to through-substrate vias (TSVs) 2306. The package interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the package interposer 2304. The package-on-interposer structure 2336 may take the form of any of the package-on-interposer structures known in the art.

The IC device assembly 2300 may include an IC package 2324 coupled to the first face 2340 of the circuit board 2302 by coupling components 2322. The coupling components 2322 may take the form of any of the embodiments discussed above with reference to the coupling components 2316, and the IC package 2324 may take the form of any of the embodiments discussed above with reference to the IC package 2320.

The IC device assembly 2300 illustrated in FIG. 7 includes a package-on-package structure 2334 coupled to the second face 2342 of the circuit board 2302 by coupling components 2328. The package-on-package structure 2334 may include an IC package 2326 and an IC package 2332 coupled together by coupling components 2330 such that the IC package 2326 is disposed between the circuit board 2302 and the IC package 2332. The coupling components 2328 and 2330 may take the form of any of the embodiments of the coupling components 2316 discussed above, and the IC packages 2326 and 2332 may take the form of any of the embodiments of the IC package 2320 discussed above. The package-on-package structure 2334 may be configured in accordance with any of the package-on-package structures known in the art.

FIG. 8 is a block diagram of an example computing device 2400 that may include one or more components including one or more IC structures with gates formed using the gate metallization method described herein, in accordance with some embodiments. For example, any suitable ones of the components of the computing device 2400 may include a die (e.g., the die 2002 of FIG. 4) having one or more IC structures with gates formed using the gate metallization method described herein. Any one or more of the components of the computing device 2400 may include an IC device 2100 of FIG. 5, an IC package 2200 of FIG. 6, or an IC device assembly 2300 of FIG. 7.

A number of components are illustrated in FIG. 8 as included in the computing device 2400, but any one or more of these components may be omitted or duplicated, as suitable for the application. In some embodiments, some or all of the components included in the computing device 2400 may be attached to one or more motherboards. In some embodiments, some or all of these components are fabricated onto a single system-on-chip (SoC) die.

Additionally, in various embodiments, the computing device 2400 may not include one or more of the components illustrated in FIG. 8, but the computing device 2400 may include interface circuitry for coupling to the one or more components. For example, the computing device 2400 may not include a display device 2412, but may include display device interface circuitry (e.g., a connector and driver circuitry) to which a display device 2412 may be coupled. In another set of examples, the computing device 2400 may not include an audio input device 2416 or an audio output device 2414 but may include audio input or output device interface circuitry (e.g., connectors and supporting circuitry) to which an audio input device 2416 or audio output device 2414 may be coupled.

The computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 2402 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. In some embodiments, the processing device 2402 may include one or more IC structures with gates formed using the gate metallization method described herein.

The computing device 2400 may include a memory 2404, which may itself include one or more memory devices such as volatile memory (e.g., DRAM), non-volatile memory (e.g., read-only memory (ROM)), flash memory, solid state memory, and/or a hard drive. In some embodiments, the memory 2404 may include memory that shares a die with the processing device 2402. This memory may be used as cache memory and may include embedded DRAM (eDRAM) or spin transfer torque MRAM. In some embodiments, the memory 2404 may include one or more IC structures with gates formed using the gate metallization method described herein.

In some embodiments, the computing device 2400 may include a communication chip 2406 (e.g., one or more communication chips). For example, the communication chip 2406 may be configured for managing wireless communications for the transfer of data to and from the computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 2406 may implement any of a number of wireless standards or protocols, including but not limited to Institute for Electrical and Electronic Engineers (IEEE) standards including Wi-Fi (IEEE 1402.11 family), IEEE 1402.16 standards (e.g., IEEE 1402.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 1402.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 1402.16 standards. The communication chip 2406 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2406 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 2406 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 2406 may operate in accordance with other wireless protocols in other embodiments. The computing device 2400 may include an antenna 2408 to facilitate wireless communications and/or to receive other wireless communications (such as AM or FM radio transmissions).

In some embodiments, the communication chip 2406 may manage wired communications, such as electrical, optical, or any other suitable communication protocols (e.g., the Ethernet). As noted above, the communication chip 2406 may include multiple communication chips. For instance, a first communication chip 2406 may be dedicated to shorter-range wireless communications such as Wi-Fi or Bluetooth, and a second communication chip 2406 may be dedicated to longer-range wireless communications such as global positioning system (GPS), EDGE, GPRS, CDMA, WiMAX, LTE, EV-DO, or others. In some embodiments, a first communication chip 2406 may be dedicated to wireless communications, and a second communication chip 2406 may be dedicated to wired communications.

The computing device 2400 may include a battery/power circuitry 2410. The battery/power circuitry 2410 may include one or more energy storage devices (e.g., batteries or capacitors) and/or circuitry for coupling components of the computing device 2400 to an energy source separate from the computing device 2400 (e.g., AC line power).

The computing device 2400 may include a display device 2412 (or corresponding interface circuitry, as discussed above). The display device 2412 may include any visual indicators, such as a heads-up display, a computer monitor, a projector, a touchscreen display, a liquid crystal display (LCD), a light-emitting diode display, or a flat panel display, for example.

The computing device 2400 may include an audio output device 2414 (or corresponding interface circuitry, as discussed above). The audio output device 2414 may include any device that generates an audible indicator, such as speakers, headsets, or earbuds, for example.

The computing device 2400 may include an audio input device 2416 (or corresponding interface circuitry, as discussed above). The audio input device 2416 may include any device that generates a signal representative of a sound, such as microphones, microphone arrays, or digital instruments (e.g., instruments having a musical instrument digital interface (MIDI) output).

The computing device 2400 may include an other output device 2418 (or corresponding interface circuitry, as discussed above). Examples of the other output device 2418 may include an audio codec, a video codec, a printer, a wired or wireless transmitter for providing information to other devices, or an additional storage device.

The computing device 2400 may include an other input device 2420 (or corresponding interface circuitry, as discussed above). Examples of the other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 2400 may include a GPS device 2422 (or corresponding interface circuitry, as discussed above). The GPS device 2422 may be in communication with a satellite-based system and may receive a location of the computing device 2400, as known in the art.

The computing device 2400 may include a security interface device 2424. The security interface device 2424 may include any device that provides security features for the computing device 2400 or for any individual components therein (e.g., for the processing device 2402 or for the memory 2404). Examples of security features may include authorization, access to digital certificates, access to items in keychains, etc. Examples of the security interface device 2424 may include a software firewall, a hardware firewall, an antivirus, a content filtering device, or an intrusion detection device.

In some embodiments, the computing device 2400 may include a temperature detection device 2426 and a temperature regulation device 2428.

The temperature detection device 2426 may include any device capable of determining temperatures of the computing device 2400 or of any individual components therein (e.g., temperatures of the processing device 2402 or of the memory 2404). In various embodiments, the temperature detection device 2426 may be configured to determine temperatures of an object (e.g., the computing device 2400, components of the computing device 2400, devices coupled to the computing device, etc.), temperatures of an environment (e.g., a data center that includes, is controlled by, or otherwise associated with the computing device 2400), and so on. The temperature detection device 2426 may include one or more temperature sensors. Different temperature sensors of the temperature detection device 2426 may have different locations within and around the computing device 2400. A temperature sensor may generate data (e.g., digital data) representing detected temperatures and provide the data to another device, e.g., to the temperature regulation device 2428, the processing device 2402, the memory 2404, etc. In some embodiments, a temperature sensor of the temperature detection device 2426 may be turned on or off, e.g., by the processing device 2402 or an external system. The temperature sensor detects temperatures when it is on and does not detect temperatures when it is off. In other embodiments, a temperature sensor of the temperature detection device 2426 may detect temperatures continuously and automatically or detect temperatures at predefined times or at times triggered by an event associated with the computing device 2400 or any components therein.

The temperature regulation device 2428 may include any device configured to change (e.g., decrease) temperatures, e.g., based on one or more target temperatures and/or based on temperature measurements performed by the temperature detection device 2426. A target temperature may be a preferred temperature. A target temperature may depend on a setting in which the computing device 2400 operates. In some embodiments, the target temperature may be 200 Kelvin degrees or lower. In some embodiments, the target temperature may be 20 Kelvin degrees or lower, or 5 Kelvin degrees or lower. Target temperatures for different objects and different environments of, or associated with, the computing device 2400 can be different. In some embodiments, cooling provided by the temperature regulation device 2428 may be a multi-stage process with temperatures ranging from room temperature to 4K or lower.

In some embodiments, the temperature regulation device 2428 may include one or more cooling devices. Different cooling device may have different locations within and around the computing device 2400. A cooling device of the temperature regulation device 2428 may be associated with one or more temperature sensors of the temperature detection device 2426 and may be configured to operate based on temperatures detected the temperature sensors. For instance, a cooling device may be configured to determine whether a detected ambient temperature is above the target temperature or whether the detected ambient temperature is higher than the target temperature by a predetermined value or determine whether any other temperature-related condition associated with the temperature of the computing device 2400 is satisfied. In response to determining that one or more temperature-related condition associated with the temperature of the computing device 2400 are satisfied (e.g., in response to determining that the detected ambient temperature is above the target temperature), a cooling device may trigger its cooling mechanism and start to decrease the ambient temperature. Otherwise, the cooling device does not trigger any cooling. A cooling device of the temperature regulation device 2428 may operate with various cooling mechanisms, such as evaporation cooling, radiation cooling, conduction cooling, convection cooling, other cooling mechanisms, or any combination thereof. A cooling device of the temperature regulation device 2428 may include a cooling agent, such as a water, oil, liquid nitrogen, liquid helium, etc. In some embodiments, the temperature regulation device 2428 may be, for example, a dilution refrigerator, a helium-3 refrigerator, or a liquid helium refrigerator. In some embodiments, the temperature regulation device 2428 or any portions thereof (e.g., one or more of the individual cooling devices) may be connected to the computing device 2400 in close proximity (e.g., less than about 1 meter) or may be provided in a separate enclosure where a dedicated heat exchanger (e.g., a compressor, a heating, ventilation, and air conditioning (HVAC) system, liquid helium, liquid nitrogen, etc.) may reside.

By maintaining the target temperatures, the energy consumption of the computing device 2400 (or components thereof) can be reduced, while the computing efficiency may be improved. For example, when the computing device 2400 (or components thereof) operates at lower temperatures, energy dissipation (e.g., heat dissipation) may be reduced. Further, energy consumed by semiconductor components (e.g., energy needed for switching transistors of any of the components of the computing device 2400) can also be reduced. Various semiconductor materials may have lower resistivity and/or higher mobility at lower temperatures. That way, the electrical current per unit supply voltage may be increased by lowering temperatures. Conversely, for the same current that would be needed, the supply voltage may be lowered by lowering temperatures. As energy corelates to the supply voltage, the energy consumption of the semiconductor components may lower too. In some implementations, the energy savings due to reducing heat dissipation and reducing energy consumed by semiconductor components of the computing device or components thereof may outweigh (sometimes significantly outweigh) the costs associated with energy needed for cooling.

The computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 2400 may be any other electronic device that processes data.

FIG. 9 is a block diagram of an example processing device 2500 that may include one or more IC structures with gates formed using the gate metallization method described herein. For example, any suitable ones of the components of the processing device 2500 may include a die (e.g., the die 2002 of FIG. 4) having one or more IC structures with gates formed using the gate metallization method described herein. Any one or more of the components of the processing device 2500 may include an IC device 2100 of FIG. 5, an IC package 2200 of FIG. 6, or an IC device assembly 2300 of FIG. 7. Any one or more of the components of the processing device 2500 may include, or be included in, a computing device 2400 of FIG. 8; for example, the processing device 2500 may be the processing device 2402 of the computing device 2400.

A number of components are illustrated in FIG. 9 as included in the processing device 2500, but any one or more of these components may be omitted or duplicated, as suitable for the application. In some embodiments, some or all of the components included in the processing device 2500 may be attached to one or more motherboards. In some embodiments, some or all of these components are fabricated on a single SoC die or coupled to a single base, e.g., to a single carrier substrate.

Additionally, in various embodiments, the processing device 2500 may not include one or more of the components illustrated in FIG. 9, but the processing device 2500 may include interface circuitry for coupling to the one or more components. For example, the processing device 2500 may not include a memory 2504, but may include display device interface circuitry (e.g., a connector and driver circuitry) to which a memory 2504 may be coupled.

The processing device 2500 may include logic circuitry 2502 (e.g., one or more circuits configured to implement logic/compute functionality). Examples of such circuits include ICs implementing one or more of input/output (I/O) functions, arithmetic operations, pipelining of data, etc.

In some embodiments, the logic circuitry 2502 may include one or more circuits responsible for read/write operations with respect to the data stored in the memory 2504. To that end, the logic circuitry 2502 may include one or more I/O ICs configured to control access to data stored in the memory 2504.

In some embodiments, the logic circuitry 2502 may include one or more high-performance compute dies, configured to perform various operations with respect to data stored in the memory 2504 (e.g., arithmetic and logic operations, pipelining of data from one or more memory dies of the memory 2504, and possibly also data from external devices/chips). In some embodiments, the logic circuitry 2502 may be configured to only control I/O access to data but not perform any operations on the data. In some embodiments, the logic circuitry 2502 may implement ICs configured to implement I/O control of data stored in the memory 2504, assemble data from the memory 2504 for transport (e.g., transport over a central bus) to devices/chips that are either internal or external to the processing device 2500, etc. In some embodiments, the logic circuitry 2502 may not be configured to perform any operations on the data besides I/O and assembling for transport to the memory 2504.

The processing device 2500 may include a memory 2504, which may include one or more ICs configure to implement memory circuitry (e.g., ICs implementing one or more of memory devices, memory arrays, control logic configured to control the memory devices and arrays, etc.). In some embodiments, the memory 2504 may be implemented substantially as described above with reference to the memory 2404 (FIG. 8). In some embodiments, the memory 2504 may be a designated device configured to provide storage functionality for the components of the processing device 2500 (e.g., local), while the memory 2404 may be configured to provide system-level storage functionality for the entire computing device 2400 (e.g., global). In some embodiments, the memory 2504 may include memory that shares a die with the logic circuitry 2502.

The processing device 2500 may include a communication device 2506, which may be implemented substantially as described above with reference to the communication chip 2406 (FIG. 8). In some embodiments, the communication device 2506 may be a designated device configured to provide communication functionality for the components of the processing device 2500 (e.g., local), while the communication chip 2406 may be configured to provide system-level communication functionality for the entire computing device 2400 (e.g., global).

The processing device 2500 may include interconnects 2508, which may include any element or device that includes an electrically conductive material for providing electrical connectivity to one or more components of, or associated with, a processing device 2500 or/and between various such components. Examples of the interconnects 2508 include conductive lines/wires (also sometimes referred to as "lines" or "metal lines" or "trenches") and conductive vias (also sometimes referred to as "vias" or "metal vias"). In some embodiments, the interconnects 2508 may be implemented as the interconnect structures 2128 of FIG. 5, described above.

The processing device 2500 may include a temperature detection device 2510 which may be implemented substantially as described above with reference to the temperature detection device 2426 of FIG. 8 but configured to determine temperatures on a more local scale, e.g., of the processing device 2500 of components thereof. In some embodiments, the temperature detection device 2510 may be a designated device configured to provide temperature detection functionality for the components of the processing device 2500 (e.g., local), while the temperature detection device 2426 may be configured to provide system-level temperature detection functionality for the entire computing device 2400 (e.g., global).

The processing device 2500 may include a temperature regulation device 2512 which may be implemented substantially as described above with reference to the temperature regulation device 2428 of FIG. 8 but configured to regulate temperatures on a more local scale, e.g., of the processing device 2500 of components thereof. In some embodiments, the temperature regulation device 2512 may be a designated device configured to provide temperature regulation functionality for the components of the processing device 2500 (e.g., local), while the temperature regulation device 2428 may be configured to provide system-level temperature regulation functionality for the entire computing device 2400 (e.g., global).

The processing device 2500 may include a battery/power circuitry 2514 which may be implemented substantially as described above with reference to the battery/power circuitry 2410 of FIG. 8. In some embodiments, the battery/power circuitry 2514 may be a designated device configured to provide battery/power functionality for the components of the processing device 2500 (e.g., local), while the battery/power circuitry 2410 may be configured to provide system-level battery/power functionality for the entire computing device 2400 (e.g., global).

The processing device 2500 may include a hardware security device 2516 which may be implemented substantially as described above with reference to the security interface device 2424 of FIG. 8. In some embodiments, the hardware security device 2516 may be a physical computing device configured to safeguard and manage digital keys, perform encryption and decryption functions for digital signatures, authentication, and other cryptographic functions. In some embodiments, the hardware security device 2516 may include one or more secure cryptoprocessors chips.

The following paragraphs provide examples of various ones of the embodiments disclosed herein.

Example 1 provides an IC structure, the IC structure including a nanoribbon including a semiconductor material; and a P-type transistor including a gate electrode at least partially wrapping around a portion of the nanoribbon, in which the gate electrode includes a stack of conductive materials, the stack including a first conductive material, a second conductive material, and a third conductive material, in which the second conductive material is between the first conductive material and the third conductive material and includes titanium.

Example 2 provides the IC structure according to example 1, in which a thickness of the second conductive material is below about 20 nanometers.

Example 3 provides the IC structure according to examples 1 or 2, in which a material composition of the first conductive material and a material composition of the second conductive material are different.

Example 4 provides the IC structure according to example 3, in which a material composition of the third conductive material and the material composition of the second conductive material are different.

Example 5 provides the IC structure according to any one of the preceding examples, in which the second conductive material further includes nitrogen.

Example 6 provides the IC structure according to any one of the preceding examples, in which at least one of the first conductive material and the third conductive material includes tungsten.

Example 7 provides the IC structure according to any one of the preceding examples, the stack further includes a fourth conductive material and a fifth conductive material, in which the third conductive material is between the second conductive material and the fourth conductive material, and the fourth conductive material is between the third conductive material and the fifth conductive material.

Example 8 provides the IC structure according to example 7, in which a material composition of the second conductive material and a material composition of the fourth conductive material are substantially the same.

Example 9 provides the IC structure according to examples 7 or 8, in which a material composition of the first conductive material and a material composition of the fifth conductive material are substantially the same.

Example 10 provides the IC structure according to any one of the preceding examples, in which the conductive materials are stacked in the stack in a direction parallel to a longitudinal axis of the nanoribbon.

Example 11 provides an IC structure, the IC structure including a nanoribbon including a semiconductor material; and a P-type transistor including a gate electrode at least partially wrapping around a portion of the nanoribbon, in which the gate electrode includes a stack of layers of conductive materials, the stack including a first layer including a first conductive material, a second layer including a second conductive material, a third layer including a third conductive material, a fourth layer including a fourth conductive material, and a fifth layer including a fifth conductive material, in which a material composition of the second layer and a material composition of the fourth layer are different from a material composition of the first layer and a material composition of the third layer.

Example 12 provides the IC structure according to example 11, in which the material composition of the second layer and the material composition of the fourth layer are substantially the same.

Example 13 provides the IC structure according to examples 11 or 12, in which the second layer and the fourth layer include titanium.

Example 14 provides the IC structure according to example 13, in which the second layer and the fourth layer further include nitrogen.

Example 15 provides the IC structure according to any one of examples 11-14, in which the material composition of the first layer and a material composition of the fifth are substantially the same.

Example 16 provides the IC structure according to any one of examples 11-15, in which the third layer is substantially in a middle of the stack.

Example 17 provides the IC structure according to any one of examples 11-16, in which the second conductive material is between the first conductive material and the third conductive material and has a thickness below about 20 nanometers.

Example 18 provides the IC structure according to any one of examples 11-17, in which the stack further includes a sixth layer including a sixth conductive material, and a seventh layer including a seventh conductive material, in which the material composition of the first layer and the material composition of the third layer are different from a material composition of the sixth layer and a material composition of the seventh layer.

Example 19 provides a method of fabricating an IC structure, the method including depositing a first liner in a first gate region and a second liner in a second gate region; depositing a first conductive material selective to the second liner; depositing a sacrificial material to line the first gate region and to pinch-off the second gate region; removing the sacrificial material from the first gate region and recessing the sacrificial material in the second gate region; removing the first liner from the first gate region; depositing a third liner in the first gate region; removing the sacrificial material from the second gate region; depositing a fourth liner in the first gate region and the second gate region; and depositing a second conductive material in the first gate region and the second gate region.

Example 20 provides the method according to example 19, further including providing a stack of one or more nanoribbons; and performing a nanoribbon release to form the first gate region and the second gate region prior to depositing the first liner.

Example 21 provides the method according to any one of examples 19-20, in which the IC structure is an IC structure according to any one of the preceding claims.

Example 22 provides an IC package that includes an IC die including an IC structure according to any one of examples 1-18; and a further IC component, coupled to the IC die.

Example 23 provides the IC package according to example 22, where the further IC component includes a package substrate.

Example 24 provides the IC package according to example 22, where the further IC component includes an interposer.

Example 25 provides the IC package according to example 22, where the further IC component includes a further IC die.

Example 26 provides a computing structure that includes a carrier substrate, and an IC structure coupled to the carrier substrate, where the IC structure is an IC structure according to any one of examples 1-18, or the IC structure is included in the IC package according to any one of claims 22-25.

Example 27 provides the computing structure according to example 26, where the computing structure is a wearable or handheld computing structure.

Example 28 provides the computing structure according to examples 26 or 27, where the computing structure further includes one or more communication chips.

Example 29 provides the computing structure according to any one of examples 26-28, where the computing structure further includes an antenna.

Example 30 provides the computing structure according to any one of examples 26- 29, where the carrier substrate is a motherboard.

Example 31 provides the IC structure according to any one of examples 1-18, in which the IC structure includes or is a part of a central processing unit.

Example 32 provides the IC structure according to any one of examples 1-31, in which the IC structure includes or is a part of a memory structure.

Example 33 provides the IC structure according to any one of examples 1-32, in which the IC structure includes or is a part of a logic circuit.

Example 34 provides the IC structure according to any one of examples 1-33, in which the IC structure includes or is a part of input/output circuitry.

Example 35 provides the IC structure according to any one of examples 1-34, in which the IC structure includes or is a part of a field programmable gate array transceiver.

Example 36 provides the IC structure according to any one of examples 1-35, in which the IC structure includes or is a part of a field programmable gate array logic.

Example 37 provides the IC structure according to any one of examples 1-36, in which the IC structure includes or is a part of a power delivery circuitry.

Example 38 provides the IC structure according to any one of examples 1-37, in which the IC structure includes or is a part of a III-V amplifier.

Example 39 provides the IC structure according to any one of examples 1-38, in which the IC structure includes or is a part of Peripheral Component Interconnect Express circuitry or Double Data Rate transfer circuitry.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a nanoribbon comprising a semiconductor material; and
a P-type transistor comprising a gate electrode at least partially wrapping around a portion of the nanoribbon, wherein the gate electrode includes a stack of conductive materials, the stack comprising a first conductive material, a second conductive material, and a third conductive material, wherein the second conductive material is between the first conductive material and the third conductive material and includes titanium.

2. The IC structure according to claim 1, wherein a thickness of the second conductive material is below about 20 nanometers.

3. The IC structure according to claim 1 or 2, wherein a material composition of the first conductive material and a material composition of the second conductive material are different.

4. The IC structure according to claim 3, wherein a material composition of the third conductive material and the material composition of the second conductive material are different.

5. The IC structure according to any one of the preceding claims, wherein the second conductive material further includes nitrogen.

6. The IC structure according to any one of the preceding claims, wherein at least one of the first conductive material and the third conductive material includes tungsten.

7. The IC structure according to any one of the preceding claims, the stack further includes a fourth conductive material and a fifth conductive material, wherein the third conductive material is between the second conductive material and the fourth conductive material, and the fourth conductive material is between the third conductive material and the fifth conductive material.

8. The IC structure according to claim 7, wherein a material composition of the second conductive material and a material composition of the fourth conductive material are substantially same.

9. The IC structure according to claim 7 or 8, wherein a material composition of the first conductive material and a material composition of the fifth conductive material are substantially same.

10. The IC structure according to any one of the preceding claims, wherein the conductive materials are stacked in the stack in a direction parallel to a longitudinal axis of the nanoribbon.

11. A method of fabricating an integrated circuit (IC) structure, the method comprising:
depositing a first liner in a first gate region and a second liner in a second gate region;
depositing a first conductive material selective to the second liner;
depositing a sacrificial material to line the first gate region and to pinch-off the second gate region;
removing the sacrificial material from the first gate region and recessing the sacrificial material in the second gate region;
removing the first liner from the first gate region;
depositing a third liner in the first gate region;
removing the sacrificial material from the second gate region;
depositing a fourth liner in the first gate region and the second gate region; and
depositing a second conductive material in the first gate region and the second gate region.

12. The method according to claim 11, further comprising:
providing a stack of one or more nanoribbons; and
performing a nanoribbon release to form the first gate region and the second gate region prior to depositing the first liner.

13. The method according to claim 11 or 12, wherein the stack of one or more nanoribbons includes a semiconductor material.

14. The method according to any one of claims 11-13, wherein the IC structure includes a P-type transistor.
